(19) Europäisches Patentamt
European Patent Office
Office européen des brevets

(11) EP 3 232 486 B1

(12) **EUROPEAN PATENT SPECIFICATION**

(45) Date of publication and mention of the grant of the patent:
**26.06.2019 Bulletin 2019/26**

(21) Application number: **15868495.1**

(22) Date of filing: **01.12.2015**

(51) Int Cl.:
***H01L 51/50*** (2006.01) ***C08K 5/3417*** (2006.01)
***C08K 5/56*** (2006.01) ***C08L 83/10*** (2006.01)
***C09D 11/00*** (2014.01) ***H01L 51/00*** (2006.01)

(86) International application number:
**PCT/JP2015/083730**

(87) International publication number:
**WO 2016/093111 (16.06.2016 Gazette 2016/24)**

(54) **INK COMPOSITION FOR ORGANIC LIGHT-EMITTING ELEMENT, AND ORGANIC LIGHT-EMITTING ELEMENT USING SAME**

TINTENZUSAMMENSETZUNG FÜR ORGANISCHES LICHTEMITTIERENDES ELEMENT UND ORGANISCHES LICHTEMITTIERENDES ELEMENT DAMIT

COMPOSITION D'ENCRE POUR ÉLÉMENT ÉLECTROLUMINESCENT ORGANIQUE, ET ÉLÉMENT ÉLECTROLUMINESCENT ORGANIQUE UTILISANT CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.12.2014 JP 2014249837**

(43) Date of publication of application:
**18.10.2017 Bulletin 2017/42**

(73) Proprietor: **DIC Corporation**
**Tokyo 174-8520 (JP)**

(72) Inventors:
- **OTSUKI Eiji**
**Sakura-shi**
**Chiba 285-8668 (JP)**
- **GOTO Yusaku**
**Sakura-shi**
**Chiba 285-8668 (JP)**
- **TANAKA Hisakazu**
**Sakura-shi**
**Chiba 285-8668 (JP)**

(74) Representative: **Adam, Holger et al**
**Kraus & Weisert**
**Patentanwälte PartGmbB**
**Thomas-Wimmer-Ring 15**
**80539 München (DE)**

(56) References cited:
**JP-A- H0 586 294**
**JP-A- H0 586 294**
**JP-A- 2002 056 980**
**JP-A- 2005 514 726**
**JP-A- 2005 514 726**
**JP-A- 2013 053 306**
**JP-A- 2014 205 830**
**JP-A- 2014 205 830**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 232 486 B1

## Description

Technical Field

The present invention relates to an ink composition for an organic light-emitting element, and an organic light-emitting element using the same.

Background Art

In recent years, an organic light-emitting element has been focused for a next-generation flat panel display or a next-generation illumination, from viewpoints of excellent visibility, low viewing angle dependence, and realization of light weight and thin layers.

An organic light-emitting element normally includes an anode, a hole transport layer, a light-emitting layer, an electron transport layer, and a cathode. When a voltage is applied to the organic light-emitting element, holes are injected to the hole transport layer from the anode, electrons are injected to the electron transport layer from the cathode, respectively, and then, the holes and the electrons are injected to the light-emitting layer. In the light-emitting layer, recombination of the injected holes and electrons is performed, and a light-emitting material in the light-emitting layer emits light with the energy generated at this time. In addition, the organic light-emitting element may not include the hole transport layer and/or the electron transport layer according to circumstances. Further, the organic light-emitting element may include other layers such as a hole injection layer and an electron injection layer.

Such an organic light-emitting element is normally formed by a dry film forming method or a wet film forming method.

In the dry film forming method, in general, vapor deposition of an organic material is performed under a vacuum environment, and a vapor deposited film is formed. Meanwhile, in the wet film forming method, in general, application of a coating solution (ink composition) including an organic material is performed, and a coating film obtained is dried to form a film.

According to the dry film forming method, a high-performance organic light-emitting element can be formed, because the purity of an organic material of a vapor deposited film is high and an even and smooth vapor deposited film is obtained. Therefore, a large number of organic light-emitting elements are currently being produced by the dry film forming method.

However, in the dry film forming method, use efficiency of the organic material is low because a shadow mask is used at the time of vapor deposition, and a high cost is necessary because it is necessary to set a vacuum environment. As a result, the dry film forming method is difficult to be applied to the enlargement of the organic light-emitting element.

Thus, in order to deal with the enlargement of the organic light-emitting element, investigations have been performed for production of an organic light-emitting element by the wet film forming method which can be performed under atmospheric pressure. For example, PTL 1 discloses the invention relating to a coating solution for forming an organic EL layer, which is used in forming an organic layer of an organic EL element. At this time, the coating solution for forming an organic EL layer includes a leveling agent, and a light-emitting material or a charge transport material, the amount of the leveling agent (L) added satisfies a relational expression represented by viscosity (cp) of L $\times$ amount (wt%) of L added to the light-emitting material or the charge transport material $< 200$. PTL 1 discloses that an organic light-emitting element can be produced by a wet film forming method such as an inkjet method or a printing method. In addition, according to the PTL 1, when a specific amount of the leveling agent is included in the coating solution for forming an organic EL layer, it is possible to solve problems such as light-emitting unevenness caused by the flatness of a film formed by the wet film forming method.

Citation List

Patent Literature

[PTL 1] JP-A-2002-56980

JP,A,2014 205830 discloses levelling agent for organic semiconductor-containing layer, composition, use and method.

JP,A,2005-514726 corresponding to WO,A,2003/019693, discloses solutions of organic semiconductors.

JP,A, H05-86294 corresponding to EP,A,0 534 476 discloses polyorganosiloxane compositions

Summary of Invention

Technical Problem

According to the invention disclosed in PTL 1, it was found that, a coating film obtained by a wet film forming method may have a certain degree of flatness, but, from a viewpoint of achieving a high-performance organic light-emitting element, ensuring the flatness may be insufficient. More specifically, the coating film formed by the wet film forming method may cause waviness attributable to the method. As a result, a desired performance of the organic light-emitting element obtained, may not be achieved.
Therefore, an object of the present invention is to provide an ink composition for an organic light-emitting element, which can prevent the generation of waviness. Solution to Problem
The present inventors have conducted intensive studies in order to solve the aforementioned problems. As a result, the inventors have found that the aforementioned problems can be solved by adding a predetermined leveling agent to an ink composition for an organic light-emitting element, thereby completing the present invention.
That is, according to the present invention, there is provided an ink composition for an organic light-emitting element including: an organic light-emitting element material; a leveling agent; and a solvent, in which the leveling agent is a block copolymer formed by performing copolymerization of at least a siloxane monomer and a hydrophobic monomer, wherein the hydrophobic monomer is an aromatic group-containing monomer.

Advantageous Effects of Invention

According to the present invention, it is possible to obtain an ink composition for an organic light-emitting element which can prevent the generation of waviness. Brief Description of Drawings
Fig. 1 is a reactor used for the synthesis of a block copolymer in Synthesis Examples.

Description of Embodiments

Hereinafter, embodiments for realizing the present invention will be described in detail.

<Ink Composition for Organic Light-Emitting Element>

An ink composition for an organic light-emitting element according to the embodiment includes an organic light-emitting element material, a leveling agent, and a solvent. At this time, the leveling agent is a block copolymer formed by performing copolymerization of at least a siloxane monomer and a hydrophobic monomer. In addition, the ink composition for an organic light-emitting element may further include a surfactant, if necessary.

[Organic Light-Emitting Element Material]

The organic light-emitting element material is not particularly limited, as long as it is a material used in a layer configuring an organic light-emitting element. In one embodiment, examples of the organic light-emitting element material which may be included in the ink composition for an organic light-emitting element include a light-emitting material used in a light-emitting layer, a hole injection material used in a hole injection layer, a hole transport material used in a hole transport layer, an electron transport material used in an electron transport layer, and an electron injection material used in an electron injection layer.

(Light-Emitting Material)

In the light-emitting layer, the light-emitting material has a function of directly or indirectly contributing to light emission performed utilizing holes and electrons. In addition, in this specification, the "light emitting" includes light emitting performed by fluorescence and light emitting performed by phosphorescence.
In one embodiment, the light-emitting material includes a host material and a dopant material.

Host Material

The host material generally has a function of transporting holes and electrons injected to the light-emitting layer.
The host material is not particularly limited, as long as it has the function described above. The host material is classified into a high-molecular host material and a low-molecular host material. In addition, in this specification, "low-molecular" means that a weight average molecular weight (Mw) is equal to or smaller than 5,000. On the other hand, in

this specification, "high-molecular" means that a weight average molecular weight (Mw) exceeds 5,000. At this time, in this specification, as the "weight average molecular weight (Mw)", a value measured by using gel permeation chromatography (GPC), in which polystyrene is used as a reference material, is used.

The high-molecular host material includes poly(9-vinylcarbazole) (PVK), polyfluorene (PF), polyphenylene vinylene (PPV), and a copolymer including monomer units thereof.

The weight average molecular weight (Mw) of the high-molecular host material is preferably greater than 5,000 and equal to or smaller than 5,000,000 and more preferably greater than 5,000 and equal to or smaller than 1,000,000.

The low-molecular host material includes 4,4'-bis(9H-carbazol-9-yl) biphenyl (CBP), bis(2-methyl-8-quinolinolate)-4-(phenylphenolato) aluminum (BAlq), 1,3-dicarbazolylbenzene (mCP), 4,4'-bis(9-carbazolyl)-2,2'-dimethylbiphenyl (CDBP), N,N'-dicarbazolyl-1,4-dimethylbenzene (DCB), 2,7-bis(diphenylphosphine oxide)-9,9-dimethylfluorescein (P06), 3,5-bis(9-carbazolyl) tetraphenylsilane (SimCP), 1,3-bis (triphenylsilyl) benzene (UGH 3), 1,3,5-tris[4-(diphenylamino)phenyl]benzene (TDAPB), and 9,9'-(p-tert-butylphenyl)-1,3-biscarbazole.

The weight average molecular weight (Mw) of the low-molecular host material is preferably 100 to 5,000 and more preferably 300 to 5,000.

Among the host materials described above, as the host material, it is preferable to use the low-molecular host material, it is more preferable to use 4,4'-bis(9H-carbazol-9-yl) biphenyl (CBP), bis(2-methyl-8-quinolinolate)-4-(phenylphenolato) aluminum (BAlq), and 9,9'-(p-tert-butylphenyl)-1,3-biscarbazole, and it is even more preferable to use 4,4'-bis(9H-carbazol-9-yl) biphenyl (CBP) and 9,9'-(p-tert-butylphenyl)-1,3-biscarbazole.

The host materials described above may be used alone or in combination of two or more kinds thereof.

The content of the host material is preferably 0.1% to 10% by mass and more preferably 0.1% to 5% by mass with respect to the total content of the ink composition for an organic light-emitting element. The content of the host material is preferably 0.1% by mass or more, because the intermolecular distance between a host molecule and a dopant molecule can be shortened. On the other hand, the content of the host material is preferably equal to or smaller than 10% by mass, because it is possible to prevent a decrease in quantum yield.

Dopant Material

The dopant material has a function of emitting light by using the energy obtained by recombination of the transported holes and electrons.

The dopant material is not particularly limited, as long as it has the function described above. The dopant material is generally classified into a high-molecular dopant material and a low-molecular dopant material.

The high-molecular dopant material includes polyphenylene vinylene (PPV), cyanopolyphenylene vinylene (CN-PPV), poly(fluorenylene ethynylene) (PFE), polyfluorene (PFO), a polythiophene polymer, polypyridine, and a copolymer including monomer units thereof.

A weight average molecular weight (Mw) of the high-molecular dopant material is preferably greater than 5,000 and equal to or smaller than 5,000,000 and more preferably greater than 5,000 and equal to or smaller than 1,000,000.

The low-molecular dopant material includes a fluorescent light-emitting material and a phosphorescent light-emitting material.

Examples of the fluorescent light-emitting material include naphthalene, perylene, pyrene, chrysene, anthracene, coumarin, p-bis(2-phenylethenyl) benzene, quinacridone, coumarin, an aluminum complex such as $Al(C_9H_6NO)_3$, rubrene, perimidone, dicyanomethylene-2-methyl-6-(p-dimethylaminostyryl)-4H-pyran (DCM), benzopyran, rhodamine, benzothioxanthene, azabenzothioxanthene, and a derivative thereof.

Examples of the phosphorescent light-emitting material include complexes including a central metal of the group 7 to group 11 in the periodic table and an aromatic ligand coordinated with the central metal.

Examples of the central metal of the group 7 to group 11 include ruthenium, rhodium, palladium, osmium, iridium, gold, platinum, silver, and copper. Among these, the central metal is preferably iridium.

Examples of the ligand include phenyl pyridine, p-tolyl pyridine, thienyl pyridine, difluorophenyl pyridine, phenyl isoquinoline, fluorenopyridine, fluorenoquinoline, acetylacetone, and a derivative thereof. Among these, the ligand is preferably phenyl pyridine, p-tolyl pyridine, or a derivative thereof, and more preferably phenyl pyridine or a derivative thereof.

Specific examples of the phosphorescent light-emitting material include tris(2-phenylpyridine) iridium ($Ir(ppy)_3$), tris(2-phenylpyridine) ruthenium, tris(2-phenylpyridine) palladium, bis(2-phenylpyridine) platinum, tris(2-phenylpyridine) osmium, tris(2-phenylpyridine) rhenium, tris[2-(p-tolyl) pyridine] iridium ($Ir(mppy)_3$), tris[2-(p-tolyl)pyridine]ruthenium, tris[2-(p-tolyl) pyridine]palladium, tris[2-(p-tolyl)pyridine]platinum, tris[2-(p-tolyl)pyridine]osmium, tris[2-(p-tolyl) pyridine]rhenium, octaethylplatinum porphyrin, octaphenylplatinum porphyrin, octaethyl palladium porphyrin, and octaphenyl palladium porphyrin.

Among these materials described above, the dopant material is preferably the low-molecular dopant material, more preferably the phosphorescent light-emitting material, and even more preferably tris[2-(p-tolyl)pyridine] iridium

$(Ir(mppy)_3)$.

A weight average molecular weight (Mw) of the low-molecular dopant material is preferably 100 to 5,000 and more preferably 100 to 3,000.

The dopant materials described above may be used alone or in combination of two or more kinds thereof.

The content of the dopant material is preferably 0.01% to 10% by mass and more preferably 0.01% to 5% by mass with respect to the total content of the ink composition for an organic light-emitting element. The content of the dopant material is preferably 0.01% by mass or more, because it is possible to increase a light emission intensity. On the other hand, the content of the dopant material is preferably equal to or smaller than 10% by mass, because it is possible to prevent a decrease in quantum yield.

Among these materials described above, as the light-emitting material, it is preferable to use the low-molecular light-emitting material, it is more preferable to use the low-molecular host material and the low-molecular dopant material, and it is even more preferable to use tris[2-(p-tolyl)pyridine]iridium $(Ir(mppy)_3)$ and 9,9'-(p-tert-butylphenyl)-1,3-biscarbazole, from a viewpoint of obtaining higher light emitting efficiency.

(Hole Injection Material)

The hole injection material has a function of incorporating holes from the anode in the hole injection layer. At this time, the holes incorporated by the hole injection material are transported to the hole transport layer or the light-emitting layer.

The hole injection material includes a phthalocyanine compound such as copper phthalocyanine; a triphenylamine derivative such as 4,4',4"-tris[phenyl(m-tolyl)amino] triphenylamine; a cyano compound such as 1,4,5,8,9,12-hexaazatriphenylene hexacarbonitrile or 2,3,5,6-tetrafluoro-7,7,8,8-tetracyano-quinodimethane; an oxide such as vanadium oxide or molybdenum oxide; amorphous carbon; and a polymer such as polyaniline (emeraldine), poly(3,4-ethylenedioxythiophene)-poly(styrenesulfonic acid) (PEDOT-PSS), or polypyrrole. Among these, the hole injection material is preferably a polymer and more preferably PEDOT-PSS.

The hole injection materials described above may be used alone or in combination of two or more kinds thereof.

The content of the hole injection material is preferably 0.01% to 10% by mass and more preferably 0.01% to 5% by mass with respect to the total content of the ink composition for an organic light-emitting element. The content of the hole injection material is preferably 0.01% by mass or more, because it is possible to effectively incorporate the holes. On the other hand, the content of the hole injection material is preferably equal to or smaller than 10% by mass, because it is possible to prevent a decrease in quantum yield.

(Hole Transport Material)

The hole transport material has a function of efficiently transporting the holes in the hole transport layer. The holes are generally transported from the hole transport material to the light-emitting layer.

The hole transport material includes a low-molecular triphenylamine derivative such as TPD (N,N'-diphenyl-N,N'-di(3-methylphenyl)-1,1'-biphenyl-4,4'diamine), α-NPD (4,4'-bis[N-(1-naphthyl)-N-phenylamino]biphenyl), or m-MTDATA (4,4',4"-tris(3-methylphenylphenylamino) triphenylamine); polyvinylcarbazole; and a polymer compound obtained by introducing a substituent to a triphenylamine derivative represented by Chemical Formula HT-2 and performing polymerization. Among these, the hole transport material is preferably a triphenylamine derivative or a polymer compound obtained by introducing a substituent to a triphenylamine derivative and performing polymerization, and more preferably HT-2.

The hole transport material described above may be used alone or in combination of two or more kinds thereof.

[Chem. 1]

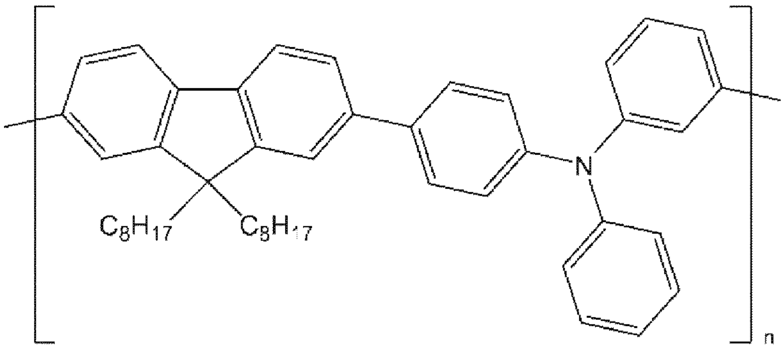

HT-2

The content of the hole transport material is preferably 0.01% to 10% by mass and more preferably 0.01% to 5% by mass with respect to the total content of the ink composition for an organic light-emitting element. The content of the hole transport material is preferably 0.01% by mass or more, because it is possible to effectively transport the holes. On the other hand, the content of the hole transport material is preferably equal to or smaller than 10% by mass, because it is possible to prevent a decrease in quantum yield.

(Electron Transport Material)

The electron transport material has a function of efficiently transporting the electrons in the electron transport layer. The electrons are generally transported from the electron transport material to the light-emitting layer.

The electron transport material includes a metal complex including a quinoline skeleton or a benzoquinoline skeleton such as tris(8-quinolinolato) aluminum (Alq), tris(4-methyl-8-quinolinolato) aluminum (Almq3), bis(10-hydroxybenzo [h] quinolinato) beryllium (BeBq2), bis(2-methyl-8-quinolinolato) (p-phenylphenolato) aluminum (BAlq), or bis(8-quinolinolato)zinc (Znq); a metal complex including a benzoxazoline skeleton such as bis[2-(2'-hydroxyphenyl) benzoxazolate] zinc (Zn(BOX)2); a metal complex including a benzothiazoline skeleton such as bis[2-(2'-hydroxyphenyl)benzothiazolato] zinc (Zn(BTZ)2); a polyazole derivative such as 2- (4-biphenylyl)-5-(4-tert-butylphenyl)-1,3,4-oxadiazole (PBD), 3-(4-biphenylyl)-4-phenyl-5-(4-ter-butylphenyl)-1,2,4-triazole (TAZ), 1,3-bis[5-(p-tert-butylphenyl)-1,3,4-oxadiazol-2-yl] benzene (OXD-7), 9-[4-(5-phenyl-1,3,4-oxadiazol-2-yl)phenyl]carbazole (CO11), 2,2',2"-(1,3,5-benzenetriyl) tris(1-phenyl-1H-benzimidazole) (TPBI), or 2-[3-(dibenzothiophen-4-yl)phenyl]-1-phenyl-1H-benzimidazole (mDBTBIm-II); a benzimidazole derivative represented by Chemical Formula ET-1; a quinoline derivative; a perylene derivative; a pyridine derivative; a pyrimidine derivative; a triazine derivative; a quinoxaline derivative; a diphenylquinone derivatives; and a nitro-substituted fluorene derivative. Among these, the electron transport material is preferably a benzimidazole derivatives, a pyridine derivative, a pyrimidine derivative or a triazine derivative.

The electron transport materials described above may be used alone or in combination of two or more kinds thereof.

[Chem. 2]

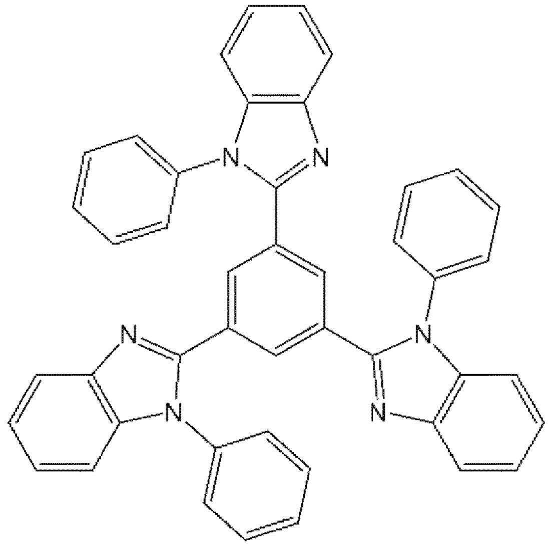

ET-1

The content of the electron transport material is preferably 0.01% to 10% by mass and more preferably 0.01% to 5% by mass with respect to the total content of the ink composition for an organic light-emitting element. The content of the electron transport material is preferably 0.01% by mass or more, because it is possible to effectively transport the electrons. On the other hand, the content of the electron transport material is preferably equal to or smaller than 10% by mass, because it is possible to prevent a decrease in quantum yield.

(Electron Injection Material)

The electron injection material has a function of incorporating electrons from the cathode in the electron injection layer. At this time, the electrons incorporated by the electron injection layer are transported to the electron transport layer or the light-emitting layer.

The electron injection material includes an alkali metal such as lithium or calcium; a metal such as strontium or aluminum; an alkali metal salt such as lithium fluoride or sodium fluoride; an alkali metal compound such as 8-hydroxyquinolyltritium; an alkaline earth metal salt such as magnesium fluoride; and an oxide such as aluminum oxide. Among these, the electron injection material is preferably an alkali metal, an alkali metal salt, or an alkali metal compound, and more preferably an alkali metal salt or an alkali metal compound.

The electron injection materials described above may be used alone or in combination of two or more kinds thereof.

The content of the electron injection material is preferably 0.01% to 10% by mass and more preferably 0.01% to 5% by mass with respect to the total content of the ink composition for an organic light-emitting element. The content of the electron injection material is preferably 0.01% by mass or more, because it is possible to effectively incorporate the electrons. On the other hand, the content of the electron injection material is preferably equal to or smaller than 10% by mass, because it is possible to prevent a decrease in quantum yield.

The organic light-emitting element material is preferably the light-emitting material or the hole transport material, more preferably the light-emitting material, and even more preferably the low-molecular light-emitting material.

[Leveling Agent]

In one embodiment, the leveling agent has a function of preventing waviness of a layer to be obtained, when forming a layer configuring an organic light-emitting element by using the ink composition for an organic light-emitting element.

In addition, in one embodiment, in the case of forming the light-emitting layer by using the ink composition for an organic light-emitting element, the leveling agent may have a function of improving the light emitting efficiency of the organic light-emitting element including the light-emitting layer formed.

The leveling agent according to the embodiment is a block copolymer formed by performing copolymerization

of at least a siloxane monomer and a hydrophobic monomer. At this time, the leveling agent may include components derived from a polymerization initiator.

(Siloxane Monomer)

The siloxane monomer includes a siloxane group, a polymerizable functional group, and a first linking group. At this time, the first linking group links the siloxane group and the polymerizable functional group to each other. In addition, in this specification, "siloxane" means a structure of "-Si-O-Si-" (siloxane structure).

The siloxane group of the siloxane monomer is preferably a component represented by Formula (1).

[Chem. 3]

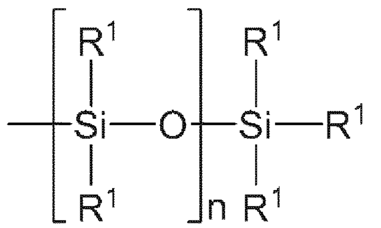
(1)

In Formula (1), $R^1$'s each independently represent a hydrogen atom, a C1 to C30 alkyl group, a C3 to C30 cycloalkyl group, and a C1 to C30 alkylsilyloxy group.

The C1 to C30 alkyl group is not particularly limited and examples thereof include methyl, ethyl, propyl, isopropyl, butyl, iso-butyl, sec-butyl, tert-butyl, pentyl, hexyl, decyl, undecyl, and octadecyl.

In addition, the C3 to C30 cycloalkyl group includes cyclopropyl, cyclobutyl, cyclopentyl, cyclohexyl, cycloheptyl, tricyclo[5,2,1,0(2,6)]decyl, and adamantyl.

The C1 to C30 alkylsilyloxy group includes methylsilyloxy, dimethylsilyloxy, trimethylsilyloxy, ethylsilyloxy, diethylsilyloxy, triethylsilyloxy, ethylmethylsilyloxy, and diethylmethylsilyloxy.

At this time, at least one of hydrogen atoms configuring the C1 to C30 alkyl group, the C3 to C30 cycloalkyl group, and the C1 to C30 alkylsilyloxy group may be substituted with a substituent. Examples of the substituent include a halogen atom; a hydroxy group; a thiol group; a nitro group; a sulfo group; a C1 to C10 alkoxy group such as a methoxy group, an ethoxy group, a propyl group, an isopropyloxy group, or a butoxy group; a C1 to C10 alkylamino group such as a methylamino group, an ethylamino group, a dimethylamino group or a diethylamino group; a C2 to C10 alkylcarbonyl group such as a methylcarbonyl group, an ethylcarbonyl group, a propylcarbonyl group, or a butylcarbonyl group; and a C2 to C10 alkyloxycarbonyl group such as a methyloxycarbonyl group, an ethyloxycarbonyl group, a propyloxycarbonyl group, or a butyloxycarbonyl group.

Among these, $R^1$ preferably includes a hydrogen atom, the C1 to C30 alkyl group, or the C1 to C30 alkylsilyloxy group, more preferably includes a hydrogen atom, methyl, ethyl, propyl, isopropyl, butyl, iso-butyl, sec-butyl, tert-butyl, trimethylsilyloxy, or triethylsilyloxy, and even more preferably includes a hydrogen atom, methyl, ethyl, propyl, or trimethylsilyloxy.

n is 1 to 1,000 and is preferably 1 to 200.

In addition, the polymerizable functional group included in the siloxane monomer is not particularly limited, and examples thereof include acryloyloxy, methacryloyloxy, glycidyl, vinyl, and vinylidene. Among these, the polymerizable functional group is preferably acryloyloxy or methacryloyloxy.

Further, examples of the first linking group included in the siloxane monomer include a single bond, an oxygen atom, a sulfur atom, a C1 to C10 alkylene group, and a C6 to C30 arylene group.

The C1 to C10 alkylene group includes methylene, ethylene, propylene, isopropylene, butylene, iso-butylene, sec-butylene, and pentylene.

The C6 to C30 arylene group includes phenylene, tolylene, naphthylene, anthracenylene, and biphenylene.

At this time, at least one of hydrogen atoms configuring the C1 to C10 alkylene group and the C6 to C30 arylene group may be substituted with the substituent described above.

Among these, the first linking group is preferably a single bond or the C1 to C10 alkylene group and more preferably a single bond, methylene, ethylene, or propylene.

Specific examples of the siloxane monomer are shown below.

[Chem. 4]

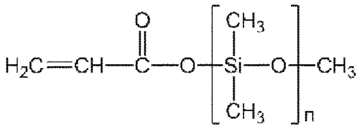
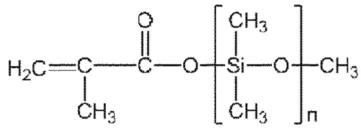
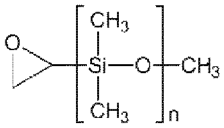
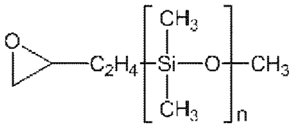
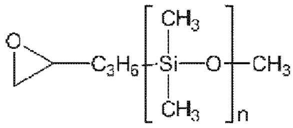
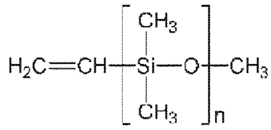
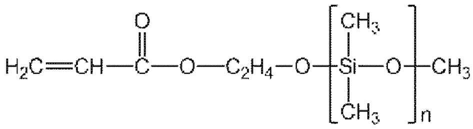
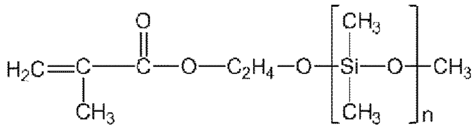
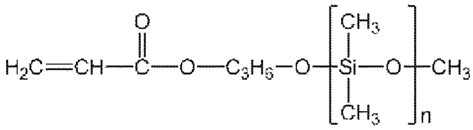
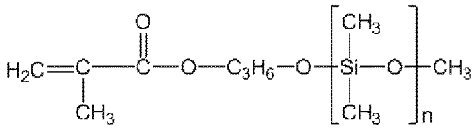
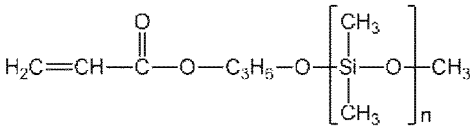
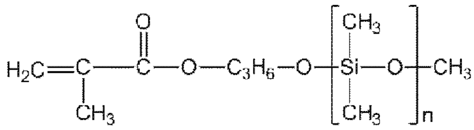
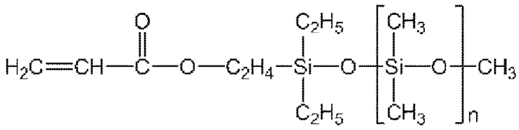
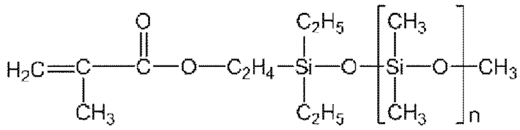
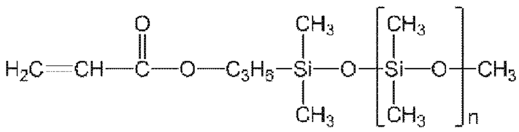
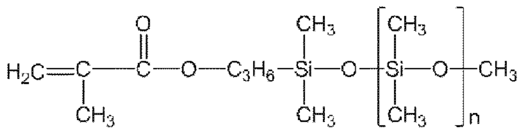
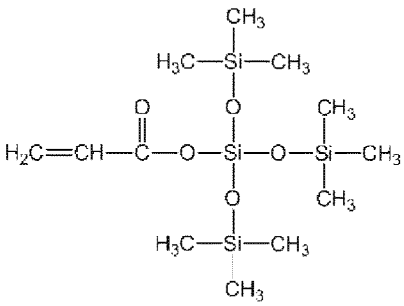
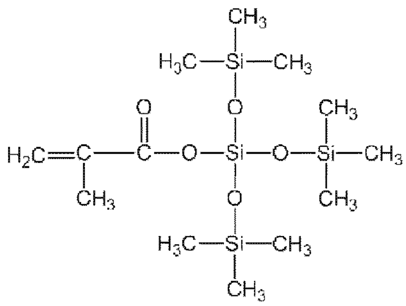
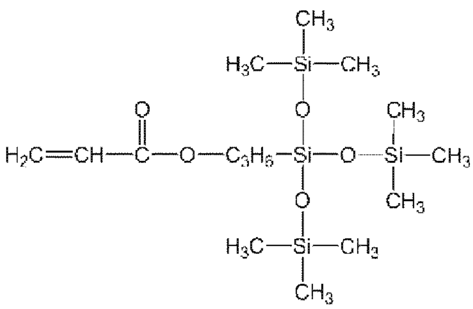
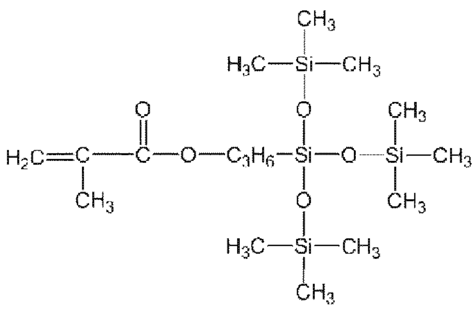

n represents an integer of 1 to 1,000.

The siloxane monomer may be used alone or in combination of two or more kinds thereof.

(Hydrophobic Monomer)

The hydrophobic monomer includes a hydrophobic group, a polymerizable functional group, and a second linking group. At this time, the second linking group links the hydrophobic group and the polymerizable functional group to each other. In addition, in this specification, the "hydrophobic group" means a group in which a solubility (25°C, 25%RH) of a molecule formed by bonding of a hydrophobic group to a hydrogen atom, with respect to water, is equal to or smaller than 100 mg/L.

The hydrophobic group includes a C1 to C30 alkyl group, a C3 to C30 cycloalkyl group, and a C6 to C30 aryl group.

The C1 to C30 alkyl group and the C3 to C30 cycloalkyl group are the same as those described above, respectively.

Examples of the C6 to C30 aryl group include phenyl, naphthyl, anthracenyl, and biphenyl.

At this time, at least one of hydrogen atoms configuring the C1 to C10 alkyl group, the C3 to C30 cycloalkyl group, and the C6 to C30 aryl group may be substituted with the substituent described above in a range of exhibiting hydrophobicity.

In addition, the polymerizable functional group included in the hydrophobic monomer is not particularly limited, and examples thereof include acryloyloxy, methacryloyloxy, glycidyl, and vinyl. Among these, the polymerizable functional group is preferably acryloyloxy, methacryloyloxy, or vinyl.

Further, examples of the second linking group included in the hydrophobic monomer include a single bond, an oxygen atom, and a sulfur atom.

Specific examples of the hydrophobic monomer include alkyl methacrylate such as methyl methacrylate, ethyl methacrylate, propyl methacrylate, isopropyl methacrylate, butyl methacrylate, 2-ethylhexyl methacrylate, stearyl methacrylate, or 2-(dimethylamino) ethyl methacrylate; alkyl acrylate such as methyl acrylate, ethyl acrylate, propyl acrylate, isopropyl acrylate, butyl acrylate, 2-ethylhexyl acrylate, stearyl acrylate, or 2-(dimethylamino)ethyl acrylate; alkyl glycidyl ether such as glycidyl methyl ether, ethyl glycidyl ether, or butyl brsidyl ether; alkyl vinyl ether such as vinyl methyl ether or ethyl vinyl ether; cycloalkyl methacrylate such as cyclopentyl methacrylate or cyclohexyl methacrylate; cycloalkyl acrylate such as cyclopentyl acrylate or cyclohexyl acrylate; cycloalkyl glycidyl ether such as cyclohexyl glycidyl ether; cycloalkyl vinyl ether such as cyclohexyl vinyl ether; aryl methacrylate such as phenyl methacrylate, naphthyl methacrylate, or benzyl methacrylate; aryl acrylate such as phenyl acrylate, naphthyl acrylate, or benzyl acrylate; aryl glycidyl ether such as glycidyl phenyl ether; aryl vinyl such as styrene or vinyl toluene; arylphenyl ether such as phenyl vinyl ether; and aryl vinylidene such as 1,1-diphenylethylene.

Among the hydrophobic monomers described above, it is preferable to use an aromatic group-containing monomer including an aryl group, it is more preferable to use aryl vinyl or aryl vinylidene, and it is even more preferable to use styrene or 1,1-diphenylethylene, from a viewpoint of more suitably obtaining an effect of improving light-emitting efficiency which will be described later.

In addition, the hydrophobic monomers described above may be used alone or in combination of two or more kinds thereof.

(Polymerization Initiator)

The polymerization initiator generally has a function of an initiator of living anionic polymerization applied when forming a block copolymer. At this time, the polymerization initiator can initiate polymerization by reacting with the polymerizable functional group of the siloxane monomer or the polymerizable functional group of the hydrophobic monomer. In this case, the block copolymer to be obtained includes components derived from the polymerization initiator.

The polymerization initiator is not particularly limited and an organic lithium compound is preferably used.

Examples of the organic lithium compound include alkyl lithium such as methyl lithium, ethyl lithium, propyl lithium, butyl lithium, sec-butyl lithium, iso-butyl lithium, tert-butyl lithium, pentyl lithium, or hexyl lithium; alkoxyalkyl lithium such as methoxymethyl lithium or ethoxymethyl lithium; alkenyl lithium such as vinyl lithium, allyl lithium, propenyl lithium, or butenyl lithium; alkynyl lithium such as ethynyl lithium, butynyl lithium, pentynyl lithium, or hexynyl lithium; aralkyl lithium such as benzyl lithium, phenylethyl lithium, or $\alpha$-methylstyryl lithium; aryl lithium such as phenyl lithium or naphthyl lithium; diarylalkyl lithium such as 1,1-diphenylethylene lithium, 1,1-diphenylhexyl lithium, 1,1-diphenyl-3-methylpentyl lithium, or 3-methyl-1,1-diphenylpentyl lithium; heterocyclic lithium such as 2-thienyl lithium, 4-pyridyl lithium, or 2-quinolyl lithium; an alkyl lithium magnesium complex such as tri(n-butyl) magnesium lithium or trimethyl magnesium lithium. Among these, it is preferable to use alkyl lithium or diarylalkyl lithium, and it is more preferable to use butyl lithium, tert-butyl lithium, or 1,1-diphenylethylene lithium.

In addition, the organic lithium compounds described above may be used alone or in combination of two or more kinds thereof.

(Leveling Agent; Block Copolymer)

The block copolymer according to the embodiment has a structure formed by performing copolymerization of the siloxane monomer and the hydrophobic monomer.

At this time, a specific structure of the block copolymer can be determined in accordance with a producing method thereof.

A producing method of the block copolymer is not particularly limited, and the block copolymer is preferably produced by living anionic polymerization.

Examples of the living anionic polymerization include (1) a method of performing anionic polymerization of a siloxane monomer by using a polymerization initiator to prepare polysiloxane, and then, performing the anionic polymerization of a hydrophobic monomer with respect to the polysiloxane, and (2) a method of performing anionic polymerization of a hydrophobic monomer by using a polymerization initiator to prepare a hydrophobic polymer, and then, performing the anionic polymerization of a siloxane monomer with respect to the hydrophobic polymer.

At this time, it is preferable to adjust the content of a siloxane structure part derived from the siloxane monomer in the leveling agent and the content of a hydrophobic part derived from the hydrophobic monomer in the leveling agent, by considering the performance of the block copolymer (leveling agent) to be obtained.

More specifically, the content of silicon of the leveling agent is preferably 0.1% by mass or more, more preferably 0.1% to 50.0% by mass, even more preferably 3% to 30% by mass, and still more preferably 5% to 15% by mass. The content of silicon of the leveling agent is preferably 0.1% by mass or more, because it is possible to reduce the surface energy. At this time, it is possible to control the value of the content of silicon by suitably adjusting the synthesis conditions of the leveling agent, for example, the amount of siloxane monomer added. In addition, in this specification, as the value of the "content of silicon", a value calculated by the following equation is used.

[Math. 1]

$$\text{Content of silicon (\% by mass)} = \frac{\text{Atomic weight of silicon x number of silicon atoms in one molecule}}{\text{Molecular weight of levelling agent}} \times 100$$

In addition, the amount of the polymerization initiator used is preferably 0.001 to 1 parts by mass, more preferably 0.005 to 0.5 parts by mass, and even more preferably 0.01 to 0.3 parts by mass, with respect to 100 parts by mass of the monomer.

Further, the polymerization reaction may be performed without a solvent or may be performed in a solvent. A solvent used when performing the polymerization in a solvent is not particularly limited, and examples thereof include an aliphatic hydrocarbon solvent such as pentane, hexane, heptane, or octane; an alicyclic hydrocarbon solvent such as cyclopentane, methylcyclopentane, cyclohexane, or methylcyclohexane; an aromatic hydrocarbon solvent such as benzene, xylene, toluene, or ethylbenzene; and a polar aprotic solvent such as tetrahydrofuran, dimethylformamide, or dimethylsulfoxide. These solvents may be used alone or in combination of two or more kinds thereof.

The amount of the solvent used in the polymerization reaction is preferably 0 to 2,000 parts by mass, more preferably 10 to 1,000 parts by mass, and even more preferably 10 to 100 parts by mass, with respect to 100 parts by mass of the amount of charge for the monomer.

As described above, the specific structure of the block copolymer can be determined in accordance with the producing method thereof, and examples of the structure of the block copolymer according to one embodiment are shown below.

[Chem. 5]

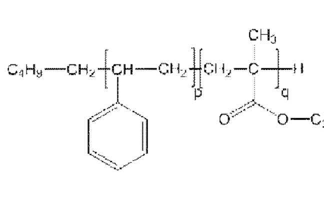
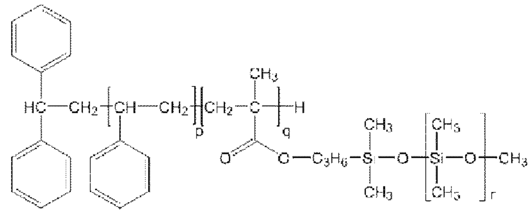
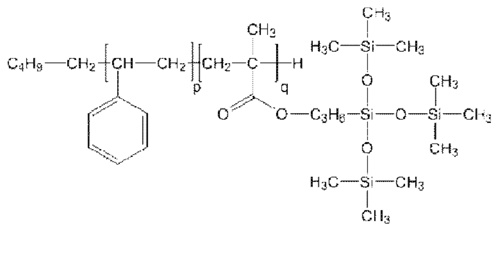
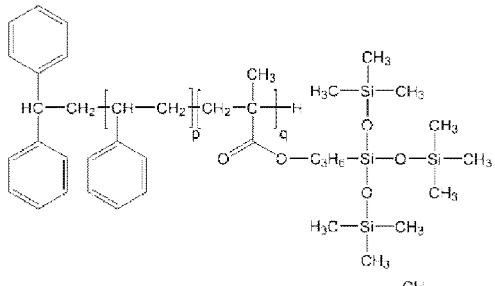
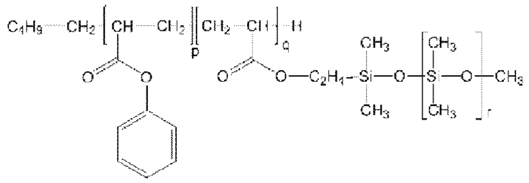
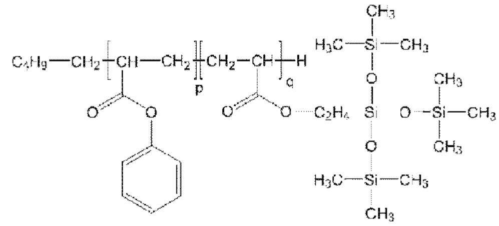
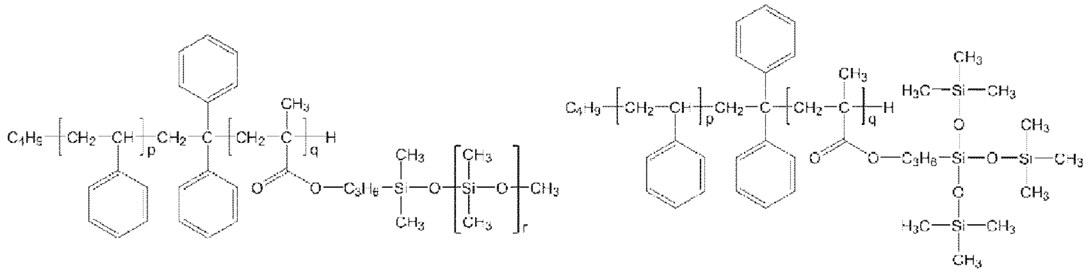

A weight average molecular weight (Mw) of the leveling agent is preferably 500 to 100,000 and more preferably 3,000 to 40,000. The weight average molecular weight (Mw) of the leveling agent is preferably in the range described above, because it is possible to prevent the waviness, and dopant molecules can be evenly dissolved and dispersed, particularly, in the case of using the ink composition for an organic light-emitting element in the formation of the light-emitting layer. In addition, in this specification, as the value of the "weight average molecular weight (Mw)", a value measured by a measurement method of Examples is used.

Further, a number average molecular weight (Mn) of the leveling agent is preferably 500 to 100,000 and more preferably 3,000 to 40,000. The number average molecular weight (Mn) of the leveling agent is preferably in the range described above, because it is possible to prevent the waviness, and dopant molecules can be evenly dissolved and dispersed, particularly, in the case of using the ink composition for an organic light-emitting element in the formation of the light-emitting layer. In addition, in this specification, as the value of the "number average molecular weight (Mn)", a value measured by a measurement method of Examples is used.

Further, a distribution (Mw/Mn) of the leveling agent is preferably 1.0 to 1.8 and more preferably 1.0 to 1.5. When the distribution of the leveling agent is in the range described above, the block copolymerization is suitably performed and the effects of the present invention are suitably exhibited as will be described later.

When the total content of the organic light-emitting element material, the leveling agent, and the solvent is set as 100% by mass, a non-volatile content of the leveling agent is preferably 0.001% to 5.0% by mass and more preferably 0.001% to 1.0% by mass. The non-volatile content of the leveling agent is preferably 0.001% by mass or more, because it is possible to prevent the generation of waviness. On the other hand, the non-volatile content of the leveling agent is preferably equal to or smaller than 5.0% by mass, because light-emitting efficiency is stable.

When a coating film is formed by applying the ink composition for an organic light-emitting element according to the embodiment, the leveling agent is oriented on the surface of the coating film to decrease the surface tension,

because the leveling agent has a siloxane structure. When the coating film obtained in such a state is dried, it is possible to prevent the generation of waviness due to drying, and it is possible to obtain a layer realizing flatness to a high degree and an organic light-emitting element having high performance. At this time, when the leveling agent is a block copolymer, it is possible to effectively exhibit a surface tension decreasing effect due to the presence of an unevenly distributed siloxane structure, as compared with the case where a random copolymer is used, and since a hydrophobic monomer-derived structure has affinity with the solvent in the ink composition for an organic light-emitting element, a hydrophobic monomer-derived structure, unevenly distributed, is suitably oriented in the coating film. Therefore, it is possible to more effectively perform coating film surface segregation of the siloxane structure, and to even more effectively exhibit the surface tension decreasing effect.

In addition, in one embodiment, in the case of using the ink composition for an organic light-emitting element in the formation of the light-emitting layer, it is also possible to exhibit a function of improving light-emitting efficiency of the organic light-emitting element. It is considered that such a function is obtained in accordance with the effect of the siloxane structure of the leveling agent with respect to the dispersibility of the light-emitting material in the light-emitting layer.

More specifically, in one embodiment, the light-emitting material includes the host material and the dopant material. In the light-emitting layer, the holes and/or the charges are transported by the host material, and the light-emitting layer emits light by using energy generated from recombination of the transported holes and electrons, by the dopant material. Therefore, when the dopant material and the host material are present to be evenly dispersed in the light-emitting layer, the light emitting can be efficiently performed in the light-emitting layer.

A leveling agent of the related art included in the ink composition for an organic light-emitting element is oriented on the surface of a coating film obtained by applying the ink composition and decreases the surface tension, but the leveling agent may have an interface segregation effect of the dopant material. In this case, the dopant material becomes unevenly distributed on the surface of the coating film together with the leveling agent, and the uneven distribution is maintained even in the light-emitting layer to be obtained. Accordingly, the transfer of the holes/charges is not efficiently performed, and the light-emitting efficiency may be deteriorated. That is, when using the leveling agent of the related art, a certain degree of an effect of preventing waviness may be obtained, but in return therefor, the light-emitting efficiency may be deteriorated.

However, when the leveling agent has a siloxane structure, it is possible to prevent or inhibit the interface segregation effect of the dopant material due to the leveling agent. As a result, the dopant material is evenly dispersed in the light-emitting layer and thus, the light-emitting efficiency can be relatively increased. At this time, when the leveling agent is a block copolymer, it is possible to effectively exhibit an interface segregation preventing (inhibiting) effect of the dopant due to the presence of an unevenly distributed siloxane structure, as compared with the case where a random copolymer is used, and it is possible to prevent aggregation of the dopant due to the presence of the unevenly distributed hydrophobic monomers.

[Solvent]

In one embodiment, the solvent used in the ink composition for an organic light-emitting element is not particularly limited, and a well-known solvent may be suitably used in accordance with a layer to be formed. Specifically, examples thereof include an aromatic solvent, an alkane solvent, an ether solvent, an alcohol solvent, an ester solvent, an amide solvent, and other solvents.

Examples of the aromatic solvent include monocyclic aromatic solvent such as toluene, xylene, ethylbenzene, cumene, pentylbenzene, hexylbenzene, cyclohexylbenzene, dodecylbenzene, mesitylene, diphenylmethane, dimethoxybenzene, phenetole, methoxytoluene, anisole, methylanisole, or dimethylanisole; a fused cyclic aromatic solvent such as cyclohexylbenzene, tetralin, naphthalene, or methylnaphthalene; an ether-based aromatic solvent such as methyl phenyl ether, ethyl phenyl ether, propyl phenyl ether, or butyl phenyl ether; and an ester-based aromatic solvent such as phenyl acetate, phenyl propionate, ethyl benzoate, propyl benzoate, or butyl benzoate.

Examples of the alkane solvent include pentane, hexane, octane, and cyclohexane.

Examples of the ether solvent include dioxane, ethylene glycol dimethyl ether, ethylene glycol diethyl ether, propylene glycol-1-monomethyl ether acetate, and tetrahydrofuran.

Examples of the alcohol solvent include methanol, ethanol, and isopropyl alcohol.

Examples of the ester solvent include ethyl acetate, butyl acetate, ethyl lactate, and butyl lactate.

Examples of the amide solvent include N,N-dimethylformamide and N,N-dimethylacetamide.

Examples of the other solvent include water, dimethylsulfoxide, acetone, chloroform, and methylene chloride.

Among these, as the solvent, it is preferable to include the aromatic solvent, it is more preferable to include at least one selected from the group consisting of the fused cyclic aromatic solvent, the ether-based aromatic solvent, and the ester-based aromatic solvent, and it is even more preferable to use the fused cyclic aromatic solvent and/or the ether-based aromatic solvent.

The solvents described above may be used alone or in combination of two or more kinds thereof.

It is preferable to use the fused cyclic aromatic solvent, the ether-based aromatic solvent, or the ester-based aromatic solvent, because it is possible to obtain a higher effect of preventing waviness, by exhibiting a suitable interaction with the leveling agent by the solvent.

In addition, it is preferable to use the fused cyclic aromatic solvent and/or the ether-based aromatic solvent, in the case of using the ink composition for an organic light-emitting element in the formation of the light-emitting layer, because it is possible to obtain a higher light emitting efficiency, by exhibiting a suitable interaction with the leveling agent and the light-emitting material by the solvent.

In one embodiment of the present invention, in the case of using the ink composition for an organic light-emitting element in the formation of the light-emitting layer, a three-dimensional coordinate distance (Ra) represented by Equation (a) relating to a relationship between the light-emitting material and the solvent is preferably equal to or smaller than 10, more preferably 0 to 9, and even more preferably 0 to 8. [Math. 1]

[Math. 1] ~~[Math. 2]~~

$$\mathrm{Ra} = \sqrt{4} \times \{(dD)^2 + (dP)^2 + (dH)^2\} \qquad \text{(a)}$$

In the equation, dD, dP, and dH are respectively a difference in a dispersion term, a difference in a polarization term, and a difference in a hydrogen bond term of Hansen solubility parameters between the light-emitting material and the solvent.

When the three-dimensional coordinate distance (Ra) (hereinafter, also referred to as "HSP-Ra") represented by Equation (a) is equal to or smaller than 10, the light-emitting material is suitably dissolved in the solvent, film forming properties are improved, and thus, it is possible to obtain a higher effect of preventing waviness.

In addition, the HSP-Ra may be an index estimating the affinity between the light-emitting material and the solvent. The Hansen solubility parameter (HSP) is an index of solubility of the light-emitting material with respect to the solvent. The solubility is represented by a three-dimensional coordinate in which a dispersion term, a polarization term, and a hydrogen bond term are respectively set as the coordinate axes, and the solubility can be determined from the difference (HSP distance) in distances between the coordinates. At this time, the dispersion term shows the Van der Waals force, the polarization term shows the force of a dipole moment, and the hydrogen bond term shows hydrogen bonding strength.

In the specific determination of the solubility, the HSP distance of the dispersion term, the polarization term, and the hydrogen bond term between the solubility parameters of the light-emitting material and the solubility parameters of the solvent, that is, the difference in the dispersion term (dD), the difference in the polarization term (dP), and the difference in the hydrogen bond term (dH) are acquired, and the three-dimensional coordinate distance (Ra) can be acquired by Equation (a). At this time, when the three-dimensional coordinate distance (Ra) is close to 0, the compatibility between the light-emitting material and the solvent is high. In this specification, as the value of the "three-dimensional coordinate distance (Ra) (HSP-Ra), a value measured and calculated by using Hansen solubility parameter calculating software HSPiP ver. 3.1.19 is used.

<Production Method of Ink Composition for Organic Light-Emitting Element>

In one embodiment of the present invention, a production method of the ink composition for an organic light-emitting element is not particularly limited, and (1) a method of preparing a solution or a dispersion including a leveling agent and a solvent, and then, adding an organic light-emitting element material into the solution or the dispersion, (2) a method of preparing a solution or a dispersion including an organic light-emitting element material and a solvent, and then, adding a leveling agent into the solution or the dispersion, or (3) a method of respectively preparing a solution or a dispersion including a leveling agent and a solvent, and a solution or a dispersion including an organic light-emitting element material and a solvent, and then, mixing these solvents or the dispersions with each other, is used.

In the case of preparing the ink composition for an organic light-emitting element of the present invention for inkjet recording, it is preferable to perform the preparation so that a viscosity thereof becomes 1 to 20 mPa, in order to ensure sufficient discharging properties.

When preparing an ink for inkjet recording, coarse particles are normally removed by centrifugal separation or filtering using a filter in an arbitrary step of the ink preparation, in order to avoid nozzle clogging due to the coarse particles.

In addition, it is preferable that high-purity products not containing impurities or ion components as much as possible are used as the organic light-emitting element material, the leveling agent, and the solvent which are raw materials used for the ink preparation, because, it is not only possible to prevent the nozzle clogging described above caused by the generation of deposits due to arbitrary reactions in the nozzle, when continuously performing inkjet

recording which will be described later, but it is also possible to sufficiently exhibit a function acquired by the layers on both outer sides of the light-emitting layer, by setting the light-emitting layer as a center layer, and obtain an excellent organic light-emitting element having high reliability, even in the continuous use over a long period of time.

An ink for inkjet recording obtained as described above can, for example, be used in a well-known and commonly used printer of an inkjet recording type of various on-demand types such as a piezo type or a thermal (bubble jet) type.

<Organic Light-Emitting Element>

According to one embodiment of the present invention, an organic light-emitting element including an anode, a light-emitting layer, and a cathode is provided. At this time, the light-emitting layer includes a leveling agent, and the leveling agent is a block copolymer formed by performing copolymerization of at least a siloxane monomer and a hydrophobic monomer, wherein the hydrophobic monomer is an aromatic group-containing monomer.

In addition, the organic light-emitting element may include one or more of other layers such as a hole injection layer, a hole transport layer, an electron transport layer, and an electron injection layer. In addition, a well-known component such as a sealing member may be included.

In addition, according to another embodiment, an organic light-emitting element including an anode, a light-emitting layer, a cathode, and at least one layer selected from the group consisting of the hole injection layer, the hole transport layer, the electron transport layer, and the electron injection layer, is provided. At this time, at least one layer selected from the group consisting of the hole injection layer, the hole transport layer, the electron transport layer, and the electron injection layer includes a leveling agent, and the leveling agent is a block copolymer formed by performing copolymerization of at least a siloxane monomer and a hydrophobic monomer, wherein the hydrophobic monomer is an aromatic group-containing monomer.

That is, the organic light-emitting element may include the anode, the light-emitting layer, the cathode as a minimum constituent unit, and may include at least one layer selected from the group consisting of the hole injection layer, the hole transport layer, the electron transport layer, and the electron injection layer as an arbitrary constituent unit. In this case, the leveling agent may be included only in the light-emitting layer, may be included only in at least one layer selected from the group consisting of the hole injection layer, the hole transport layer, the electron transport layer, and the electron injection layer (for example, only the hole transport layer, the hole transport layer and the electron transport layer), and may be included in the light-emitting layer and at least one layer of the hole injection layer, the hole transport layer, the electron transport layer, and the electron injection layer. Among these, it is preferable that the light-emitting layer and/or the hole transport layer include the leveling agent, and it is more preferable that the light-emitting layer includes the leveling agent.

Hereinafter, each configuration of the organic light-emitting element will be described in detail.

[Anode]

The anode is not particularly limited, and metal such as gold (Au), copper iodide (CuI), indium tin oxide (ITO), tin oxide ($SnO_2$), and zinc oxide can be used. These materials may be used alone or in combination of two or more kinds thereof.

A film thickness of the anode is not particularly limited, and is preferably 10 to 1,000 nm and more preferably 10 to 200 nm.

The anode can be formed by a method such as vapor deposition or sputtering. At this time, the pattern formation may be performed by a photolithographic method or a method using a mask.

[Hole Injection Layer]

The hole injection layer is an arbitrary constituent element in the organic light-emitting element and has a function of incorporating holes from the anode. Generally, the holes incorporated from the anode are transported to the hole transport layer or the light-emitting layer.

As materials which can be used in the hole injection layer, the same material described above can be used, therefore, the description thereof will be omitted here.

A film thickness of the hole injection layer is not particularly limited, and is preferably 0.1 nm to 5 $\mu$m.

The hole injection layer may be a single layer or a layer obtained by laminating two or more layers.

The hole injection layer can be formed by a wet film forming method or a dry film forming method.

In the case of forming the hole injection layer by the wet film forming method, a step of applying the ink composition for an organic light-emitting element described above and drying the obtained coating film, is generally included. At this time, the application method is not particularly limited, and examples thereof include an inkjet printing method, a relief printing method, a gravure printing method, a screen printing method, and a nozzle-print printing method.

In addition, in the case of forming the hole injection layer by the dry film forming method, a vacuum vapor deposition method or a spin coating method can be used.

[Hole Transport Layer]

The hole transport layer is an arbitrary constituent element in the organic light-emitting element and has a function of efficiently transporting the holes. In addition, the hole transport layer may have a function of preventing the transportation of the holes. Generally, the hole transport layer incorporates the holes from the anode or the hole injection layer and transports the holes to the light-emitting layer.

As materials which can be used in the hole transport layer, the same material described above can be used, therefore, the description thereof will be omitted here.

A film thickness of the hole transport layer is preferably 1 nm to 5 μm, more preferably 5 nm to 1 μm, and even more preferably 10 to 500 nm.

The hole transport layer may be a single layer or a layer obtained by laminating two or more layers.

The hole transport layer can be formed by a wet film forming method or a dry film forming method.

In the case of forming the hole transport layer by the wet film forming method, a step of applying the ink composition for an organic light-emitting element described above and drying the obtained coating film, is generally included. At this time, the application method is not particularly limited, and examples thereof include an inkjet printing method, a relief printing method, a gravure printing method, a screen printing method, and a nozzle-print printing method.

In addition, in the case of forming the hole transport layer by the dry film forming method, a vacuum vapor deposition method or a spin coating method can be used.

[Light-Emitting Layer]

The light-emitting layer has a function of causing light emission by using the energy obtained by recombination of the holes and the electrons injected to the light-emitting layer.

As materials which can be used in the light-emitting layer, the same materials described above can be used, therefore, the description thereof will be omitted here.

A film thickness of the light-emitting layer is not particularly limited, and is preferably 2 to 100 nm and more preferably 2 to 20 nm.

The light-emitting layer can be formed by a wet film forming method or a dry film forming method.

In the case of forming the light-emitting layer by the wet film forming method, a step of applying the ink composition for an organic light-emitting element described above and drying the coating film obtained, is generally included. At this time, the application method includes an inkjet printing method, a relief printing method, a gravure printing method, a screen printing method, and a nozzle-print printing method.

In addition, in the case of forming the light-emitting layer by the dry film forming method, a vacuum vapor deposition method or a spin coating method can be used.

[Electron Transport Layer]

The electron transport layer is an arbitrary constituent element in the organic light-emitting element and has a function of efficiently transporting electrons. In addition, the electron transport layer may have a function of preventing the transportation of the electrons. Generally, the electron transport layer incorporates the electrons from the cathode or the electron injection layer and transports the electrons to the light-emitting layer.

As materials which can be used in the electron transport layer, the same materials described above can be used, therefore, the description thereof will be omitted here.

A film thickness of the electron transport layer is preferably 5 nm to 5 and more preferably 5 to 200 nm.

The electron transport layer may be a single layer or a layer obtained by laminating two or more layers.

The electron transport layer can be formed by a wet film forming method or a dry film forming method.

In the case of forming the electron transport layer by the wet film forming method, a step of applying the ink composition for an organic light-emitting element described above and drying the coating film obtained, is generally included. At this time, the application method is not particularly limited, and examples thereof include an inkjet printing method, a relief printing method, a gravure printing method, a screen printing method, and a nozzle-print printing method.

In addition, in the case of forming the electron transport layer by the dry film forming method, a vacuum vapor deposition method or a spin coating method can be used.

[Electron Injection Layer]

The electron injection layer is an arbitrary constituent element in the organic light-emitting element and has a function of incorporating electrons from the cathode. Generally, the electrons incorporated from the cathode are transported to the electron transport layer or the light-emitting layer.
As materials which can be used in the electron injection layer, the same material described above can be used, therefore, the description thereof will be omitted here.
A film thickness of the electron injection layer is preferably 0.1 nm to 5 μm.
The electron injection layer may be a single layer or a layer obtained by laminating two or more layers.
The electron injection layer can be formed by a wet film forming method or a dry film forming method.
In the case of forming the electron injection layer by the wet film forming method, a step of applying the ink composition for an organic light-emitting element described above and drying the coating film obtained, is generally included. At this time, the application method is not particularly limited, and examples thereof include an inkjet printing method, a relief printing method, a gravure printing method, a screen printing method, and a nozzle-print printing method.
In addition, in the case of forming the electron injection layer by the dry film forming method, a vacuum vapor deposition method or a spin coating method can be used.

[Cathode]

The cathode includes lithium, sodium, magnesium, aluminum, a sodium-potassium alloy, a magnesium-aluminum mixture, a magnesium-indium mixture, an aluminum-aluminum oxide ($Al_2O_3$) mixture, and rare earth metal. These materials may be used alone or in combination of two or more kinds thereof.
The cathode can be generally formed by a method such as vapor deposition or sputtering.
A film thickness of the cathode is preferably 10 to 1,000 nm and more preferably 10 to 200 nm.
In one embodiment, the organic light-emitting element including layers formed by the ink composition for an organic light-emitting element described above can suitably prevent waviness of the layers to be formed. Therefore, the organic light-emitting element to be obtained has high performance of preventing the unevenness in brightness.
In addition, in another embodiment, in the case of forming the light-emitting layer by the ink composition for an organic light-emitting element described above, the organic light-emitting element to be obtained can exhibit high light-emitting efficiency. This tendency can be more significantly obtained, when the light-emitting material included in the ink composition for an organic light-emitting element is the low-molecular light-emitting material.

Examples

Hereinafter, the present invention will be described specifically with reference to Examples. In Examples, an expression "part" is used, and this indicates "part by mass", unless otherwise noted.

<Synthesis of Leveling Agent>

[Synthesis Example 1]

A block copolymer A formed by performing copolymerization of monomer including polydimethylsiloxane and a styrene monomer was synthesized.
First, the following five types of solutions were prepared.

(1) Styrene Monomer Solution (4.0 M)

145.8 g of a styrene monomer and 189.0 mL of tetrahydrofuran (THF) were put into a 100 mL eggplant flask, in which atmosphere is substituted with argon gas, with a syringe, the materials were stirred, and thus, 350 mL of a styrene monomer solution (4.0 M) was prepared.

(2) Monomer Solution Including Methacryloxypropyl Polydimethylsiloxane (0.5 M)

25.0 g of "Silaplane FM-0711" ((α-butyl-ω-(3-methacryloxypropyl)polydimethylsiloxane, average molecular weight: 1,000, manufactured by JNC Corporation), which is a monomer including methacryloxypropyl polydimethylsiloxane, and 75.0 mL of THF were put into a 100 mL eggplant flask, in which atmosphere is substituted with argon gas, with a syringe, the materials were stirred, and thus, 100 mL of a monomer solution including methacryloxypropyl polydimethylsiloxane (0.5 M) was prepared.

(3) n-Butyllithium (n-BuLi) Solution (0.1 M, Polymerization Initiator Solution)

144.2 mL of hexane was put into a 100 mL eggplant flask, in which atmosphere is substituted with argon gas, with a syringe, and the material was ice-cooled. After the ice cooling, 5.8 mL of an n-BuLi solution (2.6 M) was put into the flask and stirred, and thus, 150 mL of an n-BuLi solution (0.1 M) was prepared.

(4) 1,1-Diphenylethylene (DPE) Solution (0.1 M)

3.2 g of DPE and 176.8 mL of THF were put into a 100 mL eggplant flask, in which atmosphere is substituted with argon gas, with a syringe, the materials were stirred, and thus, 180 mL of a DPE solution (0.1 M) was prepared.

(5) Methanol (MeOH) Solution (1.5 M)

2.48 g of methanol and 46.9 mL of THF were put into a 100 mL eggplant flask, in which atmosphere is substituted with argon gas, with a syringe, the materials were stirred, and thus, 50 mL of a methanol solution (1.5 M) was prepared.

Next, the block copolymer A was synthesized by performing a copolymerization of the monomer including methacryloxypropyl polydimethylsiloxane and the styrene monomer by living anionic polymerization.

More specifically, the block copolymer A was synthesized by the living anionic polymerization using a reactor in Fig. 1.

The reactor in Fig. 1 includes three T-shaped microreactors 1 to 3 and tube reactors 4 to 10. At this time, the T-shaped microreactors 1 and 2 are embedded in a thermostatic oven at a temperature adjusted to 25°C, and the T-shaped microreactor 3 is embedded in a thermostatic oven at -30°C.

First, the BuLi solution was introduced to the T-shaped microreactor 1 from the tube reactor 7 at a flow rate of 2.0 mL/min and the styrene monomer solution was introduced to the T-shaped microreactor 1 from the tube reactor 8 at a flow rate of 5.0 mL/min, respectively. Accordingly, the living anionic polymerization of the styrene monomer proceeded (reaction temperature: 25°C), and thus, a styrene polymer solution was obtained.

Next, the styrene polymer solution obtained was introduced to the T-shaped microreactor 2 from the tube reactor 4, and then, the DPE solution was introduced to the T-shaped microreactor 2 from the tube reactor 9 at a flow rate of 2.0 ml/min. Accordingly, a growth terminal of the styrene polymer was trapped (reaction temperature: 24°C) and thus, a styrene polymer-DPE solution was obtained.

Finally, the styrene polymer-DPE solution was introduced to the T-shaped microreactor 3 from the tube reactor 5, and then, the monomer solution including methacryloxypropyl polydimethylsiloxane was introduced to the T-shaped microreactor 3 from the tube reactor 10 at a flow rate of 4.0 mL/min. Accordingly, the continuous living anionic polymerization between the styrene polymer-DPE and the monomer including methacryloxypropyl polydimethylsiloxane proceeded (reaction temperature:-30°C). Methanol was added into the reaction solution to stop the reaction, and thus, the block copolymer A was synthesized.

A structural formula of the block copolymer A is shown below.

[Chem. 6]

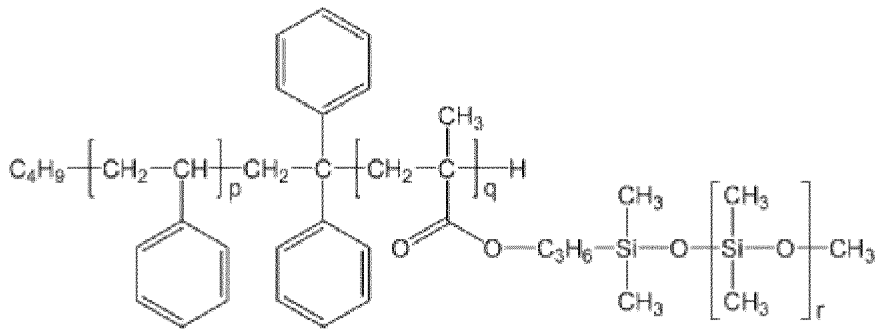

When a reaction rate (polymer conversion ratio) of the styrene monomer and a reaction rate (polymer conversion ratio) of the monomer including methacryloxypropyl polydimethylsiloxane were acquired from the amount of residual monomers in the solvent including the block copolymer A obtained, the reaction rates were respectively 100% and 99.8%.

In addition, the content of silicon was calculated by the following equation, and the content thereof was 6.3% by mass.

[Math. 3]

$$\text{Content of silicon (\% by mass)} = \frac{\text{Atomic weight of silicon x number of silicon atoms in one molecule}}{\text{Molecular weight of levelling agent}} \times 100$$

In addition, the number average molecular weight (Mn) and the weight average molecular weight (Mw) of the block copolymer A obtained were measured, and the number average molecular weight (Mn) and the weight average molecular weight (Mw) thereof were respectively 22,316 and 24,003. Accordingly, the distribution (Mw/Mn) thereof was 1.08. The number average molecular weight and the weight average molecular weight were measured by a high-speed GPC apparatus (manufactured by Tosoh Corporation) with polystyrene being used as a reference substance.

[Synthesis Example 2]

A block copolymer B was synthesized by the same method as in Synthesis Example 1, except that "Silaplane TM-0701T" (3-methacryloxypropyl tris(trimethylsiloxy) silane, average molecular weight: 423, manufactured by JNC Corporation), which is a monomer including tris(trimethylsiloxy) silyl was used as the siloxane monomer.
A structural formula of the block copolymer B is shown below.

[Chem. 7]

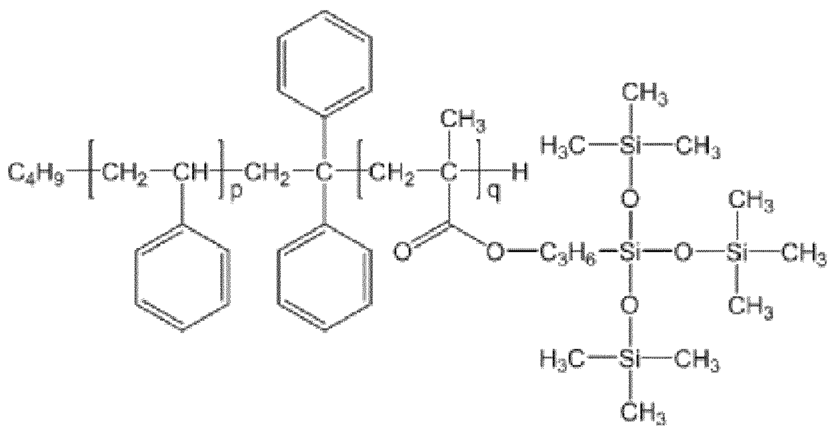

A reaction rate (polymer conversion ratio) of the styrene monomer and a reaction rate (polymer conversion ratio) of the monomer including tris(trimethylsiloxy) silyl were acquired from the amount of residual monomers in the solvent including the block copolymer B obtained, and the reaction rates were respectively 100% and 99.1%.
In addition, the content of silicon was calculated by the same method as in Synthesis Example 1, and the content thereof was 3.8% by mass.
Further, the number average molecular weight (Mn) and the weight average molecular weight (Mw) of the block copolymer B were measured by the same method as in Synthesis Example 1, and the number average molecular weight (Mn) and the weight average molecular weight (Mw) thereof were respectively 15,569 and 18,754. Accordingly, the distribution (Mw/Mn) thereof was 1.08.

[Synthesis Example 3]

A random copolymer A formed by performing copolymerization of monomer including polydimethylsiloxane and a styrene monomer was synthesized.
17.5 g of styrene and 16.8 g of "Silaplane FM-0711" (($\alpha$-butyl-$\omega$-(3-methacryloxypropyl) polydimethylsiloxane, manufactured by JNC Corporation) which is a monomer including polydimethylsiloxane were dissolved in 48.5 mL of cyclohexanone. Then, 0.69 g of perbutyl Z (manufactured by NOF Corporation) which is a polymerization initiator was added into the mixed solution obtained, the copolymerization was performed at 110°C for 48 hours, and the random copolymer A was synthesized.
A reaction rate (polymer conversion ratio) of the styrene monomer and a reaction rate (polymer conversion ratio) of the monomer including polydimethylsiloxane were acquired, and the reaction rates were respectively 98% and

100%.

In addition, the content of silicon was calculated by the same method as in Synthesis Example 1, and the content thereof was 6.3% by mass.

Further, the number average molecular weight (Mn) and the weight average molecular weight (Mw) of the random copolymer A were measured by the same method as in Synthesis Example 1, and the number average molecular weight (Mn) and the weight average molecular weight (Mw) thereof were respectively 8,431 and 24,215. Accordingly, the distribution (Mw/Mn) thereof was 2.87.

[Synthesis Example 4]

A random copolymer B formed by performing copolymerization of monomer including polydimethylsiloxane and a hydrophobic monomer was synthesized.

(1) Mixed Solution of Monomer Including Polydimethylsiloxane and Hydrophobic Monomer (0.3 M)

7.1 g (7.6 mL) of 2-(dimethylamino) ethyl methacrylate (DMAMA) which is a hydrophobic monomer, 45.0 g (46.9 mL) of "Silaplane FM-0711" ($\alpha$-butyl-$\omega$-(3-methacryloxypropyl) polydimethylsiloxane, manufactured by JNC Corporation) which is a monomer including polydimethylsiloxane, and 95.6 mL of THF were put into a 300 mL eggplant flask, in which atmosphere is substituted with argon gas, with a syringe, the materials were stirred, and thus, 150 mL of a mixed solution in which concentrations of the DMAMA and FM-0711 were respectively 0.3 M was prepared.

(2) Diphenylethylene Lithium (DPhLi) Solution (0.1 M, Polymerization Initiator Solution)

1.3 g (1.2 mL) of diphenylethylene and 66.1 mL of THF were put into a 100 mL eggplant flask, in which atmosphere is substituted with argon gas, with a syringe, the flask was immersed in a container filled with ice water to perform cooling. After the cooling, 2.7 mL of hexane solution having a concentration of n-butyllithium of 2.6 M was put with a syringe, the mixture was stirred, and thus, 70 mL of a DPhLi solution (0.1 M) was prepared.

(3) Methanol (MeOH) Solution (0.33 M)

0.53 g (0.64 mL) of MeOH and 49.4 mL of THF were put into a 100 mL eggplant flask, in which atmosphere is substituted with argon gas, with a syringe, the materials were stirred, and thus, 50 mL of the solution (0.33 M) having a concentration of MeOH of 0.33 M was prepared.

Then, the random copolymer B was synthesized by performing a random copolymerization between the monomer including polydimethylsiloxane and the hydrophobic monomer by living anionic polymerization.

More specifically, two syringe pumps "syringe pump Model 11 Plus" (manufactured by Harvard) were connected to a microreactor device including a micromixer formed of two T-shaped coupling joints and a tube reactor linked to the micromixer at a downstream side of the micromixer. Then, 50 mL gas syringes drew the mixed solution (0.3 M) of the monomer including polydimethylsiloxane and the hydrophobic monomer and the diphenylethylene lithium (DPhLi) solution (0.1 M, polymerization initiator solution), respectively, were placed in the respective syringe pumps.

The mixed solution (0.3 M) of the monomer including polydimethylsiloxane and the hydrophobic monomer and the diphenylethylene lithium (DPhLi) solution (0.1 M, polymerization initiator solution) were sent from the upstream side of a reactor configured with a micromixer (coupling joint diameter of 250 $\mu$m) and a tube reactor (inner diameter of 1 mm, length of 100 cm) at rates of 2.7 mL/min and 2 mL/min, respectively. Accordingly, the random polymerization of the monomer including polydimethylsiloxane and the hydrophobic monomer proceeded. Finally, a predetermined amount of the methanol (MeOH) solution was added into the reaction solution to stop the polymerization reaction, and accordingly, the random copolymer B of the monomer including polydimethylsiloxane and the hydrophobic monomer was synthesized. At this time, a reaction temperature was adjusted to -28°C by embedding the entire microreactor in a thermostatic oven.

A reaction rate (polymer conversion ratio) of the hydrophobic monomer and a reaction rate (polymer conversion ratio) of the monomer including polydimethylsiloxane were acquired from the amount of residual monomers in the solvent including the random copolymer B obtained, and the reaction rates were respectively 100% and 99%.

In addition, the content of silicon was calculated by the same method as in Synthesis Example 1, and the content thereof was 16.0% by mass.

Further, the number average molecular weight (Mn) and the weight average molecular weight (Mw) of the random copolymer B obtained were measured by the same method as in Synthesis Example 1, and the number average molecular weight (Mn) and the weight average molecular weight (Mw) thereof were respectively 8,508 and 10,800. Accordingly, the distribution (Mw/Mn) thereof was 1.27.

<Production of Ink Composition for Organic Light-Emitting Element>

The ink composition for an organic light-emitting element using the light-emitting material as the organic light-emitting element material was produced.

[Example 1]

0.01 g of the block copolymer A synthesized in Synthesis Example 1 was dissolved in 99.9 g of hexylbenzene which is a solvent. 0.004 g of tris[2-(p-tolyl) pyridine] iridium (Ir(mppy)$_3$) (manufactured by Luminescence Technology Corporation) and 0.026 g of 9,9'-(p-tert-butylphenyl)-1,3-biscarbazole H-1 (manufactured by DIC Corporation) were added into the obtained solvent and heated at 60°C, and accordingly, the ink composition for an organic light-emitting element was produced.

The three-dimensional coordinate distance (Ra) (RSP-Ra) regarding hexylbenzene and tris[2-(p-tolyl) pyridine] iridium (Ir(mppy)$_3$) was measured and calculated by using Hansen solubility parameter calculating software HSPiP ver. 3.1.19, and the three-dimensional coordinate distance (Ra) (RSP-Ra) was 10.3.

[Example 2]

The ink composition for an organic light-emitting element was produced by the same method as in Example 1, except that the solvent used was changed to pentylbenzene.

The RSP-Ra regarding pentylbenzene and tris[2-(p-tolyl) pyridine] iridium (Ir(mppy)$_3$) was measured and calculated by the same method as in Example 1, and the RSP-Ra was 10.2.

[Example 3]

The ink composition for an organic light-emitting element was produced by the same method as in Example 1, except that the solvent used was changed to dodecylbenzene.

The RSP-Ra regarding dodecylbenzene and tris[2-(p-tolyl) pyridine] iridium (Ir(mppy)$_3$) was measured and calculated by the same method as in Example 1, and the RSP-Ra was 11.2.

[Example 4]

The ink composition for an organic light-emitting element was produced by the same method as in Example 1, except that the solvent used was changed to cyclohexylbenzene.

The RSP-Ra regarding cyclohexylbenzene and tris[2-(p-tolyl) pyridine] iridium (Ir(mppy)$_3$) was measured and calculated by the same method as in Example 1, and the RSP-Ra was 8.4.

[Example 5]

The ink composition for an organic light-emitting element was produced by the same method as in Example 1, except that the solvent used was changed to cumene.

The RSP-Ra regarding cumene and tris[2-(p-tolyl) pyridine] iridium (Ir(mppy)$_3$) was measured and calculated by the same method as in Example 1, and the RSP-Ra was 8.6.

[Example 6]

The ink composition for an organic light-emitting element was produced by the same method as in Example 1, except that the solvent used was changed to tetralin.

The RSP-Ra regarding tetralin and tris[2-(p-tolyl) pyridine] iridium (Ir(mppy)$_3$) was measured and calculated by the same method as in Example 1, and the RSP-Ra was 6.3.

[Example 7]

The ink composition for an organic light-emitting element was produced by the same method as in Example 1, except that the solvent used was changed to 1-methylnaphthalene.

The RSP-Ra regarding 1-methylnaphthalene and tris[2-(p-tolyl) pyridine] iridium (Ir(mppy)$_3$) was measured and calculated by the same method as in Example 1, and the RSP-Ra was 7.9.

[Example 8]

The ink composition for an organic light-emitting element was produced by the same method as in Example 1, except that the solvent used was changed to butyl phenyl ether.
The RSP-Ra regarding butyl phenyl ether and tris[2-(p-tolyl) pyridine] iridium ($Ir(mppy)_3$) was measured and calculated by the same method as in Example 1, and the RSP-Ra was 9.6.

[Example 9]

The ink composition for an organic light-emitting element was produced by the same method as in Example 1, except that the solvent used was changed to phenyl acetate.
The RSP-Ra regarding phenyl acetate and tris[2-(p-tolyl) pyridine] iridium ($Ir(mppy)_3$) was measured and calculated by the same method as in Example 1, and the RSP-Ra was 7.5.

[Example 10]

The ink composition for an organic light-emitting element was produced by the same method as in Example 1, except that the block copolymer B synthesized in Synthesis Example 2 was used instead of the block copolymer A.

[Example 11]

The ink composition for an organic light-emitting element was produced by the same method as in Example 10, except that the solvent used was changed to pentylbenzene.

[Example 12]

The ink composition for an organic light-emitting element was produced by the same method as in Example 10, except that the solvent used was changed to dodecylbenzene.

[Example 13]

The ink composition for an organic light-emitting element was produced by the same method as in Example 10, except that the solvent used was changed to cyclohexylbenzene.

[Example 14]

The ink composition for an organic light-emitting element was produced by the same method as in Example 10, except that the solvent used was changed to cumene.

[Example 15]

The ink composition for an organic light-emitting element was produced by the same method as in Example 10, except that the solvent used was changed to tetralin.

[Example 16]

The ink composition for an organic light-emitting element was produced by the same method as in Example 10, except that the solvent used was changed to 1-methylnaphthalene.

[Example 17]

The ink composition for an organic light-emitting element was produced by the same method as in Example 10, except that the solvent used was changed to butyl phenyl ether.

[Example 18]

The ink composition for an organic light-emitting element was produced by the same method as in Example 10, except that the solvent used was changed to phenyl acetate.

[Comparative Example 1]

The ink composition for an organic light-emitting element was produced by the same method as in Example 1, except that dimethylsiloxane KF-96 (manufactured by Shin-Etsu Chemical Co., Ltd.) was used instead of the block copolymer A and the solvent used was changed to tetralin.

[Comparative Example 2]

The ink composition for an organic light-emitting element was produced by the same method as in Example 1, except that the random copolymer A was used instead of the block copolymer A.

[Comparative Example 3]

The ink composition for an organic light-emitting element was produced by the same method as in Comparative Example 2, except that the solvent used was changed to pentylbenzene.

[Comparative Example 4]

The ink composition for an organic light-emitting element was produced by the same method as in Comparative Example 2, except that the solvent used was changed to dodecylbenzene.

[Comparative Example 5]

The ink composition for an organic light-emitting element was produced by the same method as in Example 1, except that the random copolymer B was used instead of the block copolymer A.

Table 1 shows the ink compositions for an organic light-emitting element produced in Examples 1 to 18 and Comparative Examples 1 to 5.

[Table 1]

| | Leveling agent | | | | | Kind of solvent | HSP-Ra |
|---|---|---|---|---|---|---|---|
| | Siloxane part of siloxane monomer | Hydrophobic monomer | Content of silicon (% by mass) | Polymerization shape | Others | | |
| Example 1 | Polydimethylsiloxane | Styrene | 6.3 | Block | - | Hexylbenzene | 10.3 |
| Example 2 | Polydimethylsiloxane | Styrene | 6.3 | Block | - | Pentylbenzene | 10.2 |
| Example 3 | Polydimethylsiloxane | Styrene | 6.3 | Block | - | Dodecylbenzene | 11.2 |
| Example 4 | Polydimethylsiloxane | Styrene | 6.3 | Block | - | Cyclohexylbenzene | 8.4 |
| Example 5 | Polydimethylsiloxane | Styrene | 6.3 | Block | - | Cumene | 8.6 |
| Example 6 | Polydimethylsiloxane | Styrene | 6.3 | Block | - | Tetralin | 6.3 |
| Example 7 | Polydimethylsiloxane | Styrene | 6.3 | Block | - | 1-methylnaphthalene | 7.9 |
| Example 8 | Polydimethylsiloxane | Styrene | 6.3 | Block | - | Butyl phenyl ether | 9.6 |
| Example 9 | Polydimethylsiloxane | Styrene | 6.3 | Block | - | Phenyl acetate | 7.5 |
| Example 10 | Tris(trimethylsiloxy) silyl | Styrene | 3.8 | Block | - | Hexylbenzene | 10.3 |
| Example 11 | Tris(trimethylsiloxy) silyl | Styrene | 3.8 | Block | - | Pentylbenzene | 10.2 |
| Example 12 | Tris(trimethylsiloxy) silyl | Styrene | 3.8 | Block | - | Dodecylbenzene | 11.2 |
| Example 13 | Tris(trimethylsiloxy) silyl | Styrene | 3.8 | Block | - | Cyclohexylbenzene | 8.4 |
| Example 14 | Tris(trimethylsiloxy) silyl | Styrene | 3.8 | Block | - | Cumene | 8.6 |
| Example 15 | Tris(trimethylsiloxy) silyl | Styrene | 3.8 | Block | - | Tetralin | 6.3 |
| Example 16 | Tris(trimethylsiloxy) silyl | Styrene | 3.8 | Block | - | 1-methylnaphthalene | 7.9 |
| Example 17 | Tris(trimethylsiloxy) silyl | Styrene | 3.8 | Block | - | Butyl phenyl ether | 9.6 |

(continued)

| | Leveling agent | | | | | Kind of solvent | HSP-Ra |
|---|---|---|---|---|---|---|---|
| | Siloxane part of siloxane monomer | Hydrophobic monomer | Content of silicon (% by mass) | Polymerization shape | Others | | |
| Example 18 | Tris(trimethylsiloxy) silyl | Styrene | 3.8 | Block | - | Phenyl acetate | 7.5 |
| Comparative Example 1 | - | - | - | - | Dimethylsiloxane | Tetralin | 6.3 |
| Comparative Example 2 | Polydimethylsiloxane | Styrene | 6.3 | Random | - | Hexylbenzene | 10.3 |
| Comparative Example 3 | Polydimethylsiloxane | Styrene | 6.3 | Random | - | Pentylbenzene | 10.2 |
| Comparative Example 4 | Polydimethylsiloxane | Styrene | 6.3 | Random | - | Dodecylbenzene | 11.2 |
| Comparative Example 5 | Polydimethylsiloxane | DMAEM* | 16.0 | Random | - | Hexylbenzene | 10.3 |

*DMAEM: 2-(dimethylamino) ethyl acrylate

<Evaluation>

Various evaluations regarding the ink compositions for an organic light-emitting element produced in Examples 1 to 18 and Comparative Examples 1 to 5 were performed.

[Film Quality Evaluation (Measure for Evaluation of Generation of Waviness)

0.1 μL of the ink composition for an organic light-emitting element was added dropwise on an indium tin oxide (ITO) substrate and dried under reduced pressure at 25°C at 1 Torr. A film thickness of a protrusion and a film thickness of a recess of an organic thin film obtained were measured with a light interference surface shape measurement device (manufactured by Mitsubishi Chemical Systems), and evaluated based on the following criteria. A protrusion indicates the highest part of the surface of the organic thin film with respect to the horizontal surface as a reference, and a recess indicates the lowest part of the surface of the organic thin film with respect to the horizontal surface as a reference.

A: the value (film thickness of protrusion/film thickness of recess) of the film thickness of the protrusion with respect to the film thickness of the recess is equal to or smaller than 2.0.

B: the value (film thickness of protrusion/film thickness of recess) of the film thickness of the protrusion with respect to the film thickness of the recess is greater than 2.0 and equal to or smaller than 2.5.

C: the value (film thickness of protrusion/film thickness of recess) of the film thickness of the protrusion with respect to the film thickness of the recess is greater than 2.5 and equal to or smaller than 3.0.

D: the value (film thickness of protrusion/film thickness of recess) of the film thickness of the protrusion with respect to the film thickness of the recess is greater than 3.0.

Table 2 shows the obtained results.

[Unevenness in Brightness]

The organic light-emitting element was produced and the unevenness in brightness of the organic light-emitting element obtained was measured.

The organic light-emitting element was produced as follows.

That is, a cleaned ITO substrate was irradiated with $UV/O_3$, a film of poly(3,4-ethylenedioxythiophene)-poly(styrenesulfonic acid) (PEDOT-PSS) having a thickness of 45 nm was formed by spin coating and heated at 180°C in the atmosphere for 15 minutes, thereby forming a hole injection layer. Then, a film which was formed from 0.3% by weight of a xylene solution of HT-2 represented by the following formula and had a thickness of 10 nm was formed on the hole injection layer by spin coating and dried at 200°C under the nitrogen atmosphere for 30 minutes, and thus, the hole transport layer was formed. Next, a film which was formed from the ink composition for an organic light-emitting element and had a thickness of 30 nm was formed on the hole transport layer by spin coating and dried at 110°C in the nitrogen atmosphere for 15 minutes, and thus, the light-emitting layer was formed. A film which was formed of ET-1 represented by the following formula and had a thickness of 45 nm was formed as the electron transport layer, and a film which was formed of lithium fluoride and had a thickness of 0.5 nm was formed as the electron injection layer, and a film which was formed of aluminum and had a thickness of 100 nm was formed as the cathode, in this order, under vacuum conditions at $5 \times 10^{-3}$ Pa. Finally, the substrate was transported to a glove box, sealing was performed with a glass substrate, and thus, the organic light-emitting element was produced.

[Chem. 8]

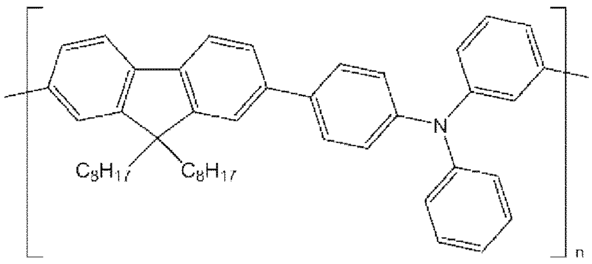

HT-2

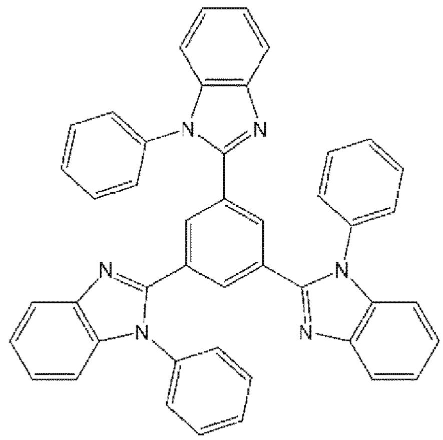

ET-1

An external source was connected to the organic light-emitting element produced as described above, a current of 10 mA was applied, and light emission from the organic light-emitting element was measured by BM-9 (manufactured by Topcon Corporation). At this time, the maximum value, the minimum value, and the in-plane average brightness of the brightness of the organic light-emitting element were respectively measured and a variation rate of brightness was obtained by the following equation.

[Math. 4]

$$\text{variation rate of brightness (\%)} = \frac{\text{maximum value of brightness} - \text{minimum value of brightness}}{\text{in-plane average brightness}} \times 100$$

The unevenness in brightness was evaluated based on the following criteria.
A: the variation rate of the brightness is equal to or smaller than 30%.
B: the variation rate of the brightness is greater than 30% and equal to or smaller than 50%.
C: the variation rate of the brightness is greater than 50% and equal to or smaller than 70%.
D: the variation rate of the brightness is greater than 70%.

Table 2 shows the obtained results.

[Light-Emitting Efficiency]

The light-emitting efficiency was evaluated by using the organic light-emitting element produced for evaluating the unevenness in brightness.
More specifically, an external source was connected to the produced organic light-emitting element, a current of 10 mA was applied, and light emission from the organic light-emitting element was measured by BM-9 (manufactured by Topcon Corporation). The light-emitting efficiency at 10 $mA/cm^2$ is calculated based on the current value, and was evaluated based on the following criteria.
A: the light-emitting efficiency is equal to or greater than 30 cd/A.
B: the light-emitting efficiency is equal to or greater than 25 cd/A and smaller than 30 cd/A.
C: the light-emitting efficiency is equal to or greater than 20 cd/A and smaller than 25 cd/A.
D: the light-emitting efficiency is smaller than 20 cd/A.

Table 2 shows the obtained results.

[Table 2]

| | Film quality | Unevenness in brightness | Light-emitting efficiency |
|---|---|---|---|
| Example 1 | C | C | C |
| Example 2 | C | C | C |
| Example 3 | C | C | D |
| Example 4 | B | B | A |
| Example 5 | A | A | B |
| Example 6 | A | A | A |
| Example 7 | A | A | A |
| Example 8 | B | B | A |
| Example 9 | A | A | B |
| Example 10 | C | C | C |
| Example 11 | C | C | C |
| Example 12 | C | C | D |
| Example 13 | C | C | B |
| Example 14 | B | B | B |
| Example 15 | B | B | A |
| Example 16 | B | B | A |
| Example 17 | B | B | A |
| Example 18 | B | B | B |
| Comparative Example 1 | D | D | D |
| Comparative Example 2 | D | D | D |
| Comparative Example 3 | D | D | D |
| Comparative Example 4 | D | D | D |
| Comparative Example 5 | D | D | D |

As shown in the results in Table 2, it is found that, in the case where the coating film was formed by using the ink compositions for an organic light-emitting element of Examples 1 to 18, excellent film quality is obtained and it is possible to prevent the waviness, as compared with Comparative Examples 1 to 5. It is found from the evaluation of the unevenness in brightness that, an organic light-emitting element having a high performance is obtained by preventing the waviness.

In addition, it is found that the organic light-emitting element obtained by using the ink compositions for an organic light-emitting element of Examples 1 to 18 also has excellent light-emitting efficiency, as compared with Comparative Examples 1 to 5.

Reference Signs List

| | |
|---|---|
| 1, 2, 3 | T-shaped micromixer |
| 4, 5, 6, 7, 8, 9, 10 | tube reactor |

## Claims

1. An ink composition for an organic light-emitting element, comprising:

an organic light-emitting element material;
a leveling agent; and
a solvent,
wherein the leveling agent is a block copolymer formed by performing copolymerization of at least a siloxane monomer and a hydrophobic monomer,
wherein the hydrophobic monomer is an aromatic group-containing monomer.

2. The ink composition for an organic light-emitting element according to claim 1,
wherein the content of silicon of the leveling agent is 0.1% by mass or more.

3. The ink composition for an organic light-emitting element according to claim 1 or 2,
wherein the solvent contains at least one selected from the group consisting of a fused cyclic aromatic solvent, an ether-based aromatic solvent, and an ester-based aromatic solvent.

4. The ink composition for an organic light-emitting element according to any one of claims 1 to 3,
wherein the organic light-emitting element material is a light-emitting material.

5. The ink composition for an organic light-emitting element according to claim 4,
wherein the light-emitting material is a low-molecular light-emitting material,
wherein low-molecular means that a weight average molecular weight (Mw) is equal to or smaller than 5,000.

6. The ink composition for an organic light-emitting element according to claim 4 or 5,
wherein a three-dimensional coordinate distance (Ra) represented by the following Equation (a) is 10 or less:

[Math. 1]

$$\mathbf{Ra} = \sqrt{4} \times \{(dD)^2 + (dP)^2 + (dH)^2\} \qquad \textbf{(a)}$$

wherein dD, dP, and dH are a difference in a dispersion term, a difference in a polarization term, and a difference in a hydrogen bond term, with respect to Hansen solubility parameters between the light-emitting material and the solvent, respectively,
wherein a value measured and calculated by using Hansen solubility parameter calculating Software HSPiP ver. 3.1.19 is used.

7. An organic light-emitting element comprising:

an anode;
a light-emitting layer; and
a cathode,
wherein the light-emitting layer includes a leveling agent, and
the leveling agent is a block copolymer formed by performing copolymerization of at least a siloxane monomer and a hydrophobic monomer,
wherein the hydrophobic monomer is an aromatic group-containing monomer.

8. An organic light-emitting element comprising:

an anode;
a light-emitting layer;
a cathode; and
at least one layer selected from the group consisting of a hole injection layer, a hole transport layer, an electron transport layer, and an electron injection layer,
wherein at least one layer selected from the group consisting of the hole injection layer, the hole transport layer, the electron transport layer, and the electron injection layer includes a leveling agent, and
the leveling agent is a block copolymer formed by performing copolymerization of at least a siloxane monomer and a hydrophobic monomer,
wherein the hydrophobic monomer is an aromatic group-containing monomer.

9. The organic light-emitting element according to claim 7 or 8, wherein the content of silicon of the leveling agent is from 0.1% to 50.0% by mass.

## Patentansprüche

1. Tintenzusammensetzung für ein organisches lichtemittierendes Element, umfassend:

   ein organisches lichtemittierendes Elementmaterial;
   ein Nivellierungsmittel und
   ein Lösungsmittel,
   wobei das Nivellierungsmittel ein Blockcopolymer ist, gebildet durch Ausführen einer Copolymerisierung von wenigstens einem Siloxanmonomer und einem hydrophoben Monomer,
   wobei das hydrophobe Monomer ein aromatische-Gruppe-haltiges Monomer ist.

2. Tintenzusammensetzung für ein organisches lichtemittierendes Element gemäß Anspruch 1, wobei der Gehalt an Silicium in dem Nivellierungsmittel 0,1 Massen-% oder mehr ist.

3. Tintenzusammensetzung für ein organisches lichtemittierendes Element gemäß Anspruch 1 oder 2, wobei das Lösungsmittel wenigstens eines enthält, ausgewählt aus der Gruppe, bestehend aus einem kondensierten cyclischen aromatischen Lösungsmittel, einem etherbasierten aromatischen Lösungsmittel und einem esterbasierten aromatischen Lösungsmittel.

4. Tintenzusammensetzung für ein organisches lichtemittierendes Element gemäß einem der Ansprüche 1 bis 3, wobei das organische lichtemittierende Elementmaterial ein lichtemittierendes Material ist.

5. Tintenzusammensetzung für ein organisches lichtemittierendes Element gemäß Anspruch 4, wobei das lichtemittierende Material ein niedermolekulares lichtemittierendes Material ist, wobei niedermolekular bedeutet, dass das gewichtsmittlere Molekulargewicht (Mw) gleich oder geringer ist als 5000.

6. Tintenzusammensetzung für ein organisches lichtemittierendes Element gemäß Anspruch 4 oder 5, wobei die dreidimensionale Koordinatendistanz (Ra), dargestellt durch die folgende Gleichung (a), 10 oder weniger beträgt:

   [Math. 1]

$$\mathbf{Ra} = \sqrt{4} \times \{(dD)^2 + (dP)^2 + (dH)^2\} \qquad \text{(a)}$$

   worin dD, dP und dH die Differenz bezüglich des Dispersionsterms, die Differenz bezüglich des Polarisationsterms und die Differenz bezüglich des Wasserstoffbindungsterms sind, in Bezug auf die Hansen-Löslichkeitsparameter zwischen dem lichtemittierenden Material bzw. dem Lösungsmittel,
   wobei ein Wert verwendet wird, der bestimmt und errechnet wird unter Verwendung der Hansen-Löslichkeitsparameter-Berechnungssoftware HSPiP Ver. 3.1.19.

7. Organisches lichtemittierendes Element, umfassend:

   eine Anode;
   eine lichtemittierende Schicht und
   eine Kathode,
   wobei die lichtemittierende Schicht ein Nivellierungsmittel umfasst, und
   das Nivellierungsmittel ein Blockcopolymer ist, gebildet durch Ausführen einer Copolymerisierung von wenigstens einem Siloxanmonomer und einem hydrophoben Monomer,
   wobei das hydrophobe Monomer ein aromatische-Gruppe-haltiges Monomer ist.

8. Organisches lichtemittierendes Element, umfassend:

   eine Anode;

eine lichtemittierende Schicht;
eine Kathode und
wenigstens eine Schicht, ausgewählt aus der Gruppe, bestehend aus einer Lochinjektionsschicht, einer Lochtransportschicht, einer Elektronentransportschicht und einer Elektroneninjektionsschicht,
wobei wenigstens eine Schicht, ausgewählt aus der Gruppe, bestehend aus der Lochinjektionsschicht, der Lochtransportschicht, der Elektronentransportschicht und der Elektroneninjektionsschicht ein Nivellierungsmittel umfasst, und
das Nivellierungsmittel ein Blockcopolymer ist, gebildet durch Ausführen einer Copolymerisierung von wenigstens einem Siloxanmonomer und einem hydrophoben Monomer,
wobei das hydrophobe Monomer ein aromatische-Gruppe-haltiges Monomer ist.

**9.** Organisches lichtemittierendes Element gemäß Anspruch 7 oder 8,
wobei der Siliciumgehalt des Nivellierungsmittels von 0,1% bis 50% nach Masse beträgt.

## Revendications

**1.** Composition d'encre pour un élément électroluminescent organique, comprenant :

un matériau d'élément électroluminescent organique ;
un agent d'unisson ; et
un solvant,
dans laquelle l'agent d'unisson est un copolymère séquencé formé en réalisant une copolymérisation d'au moins un monomère de siloxane et un monomère hydrophobe,
dans laquelle le monomère hydrophobe est un monomère contenant un groupe aromatique.

**2.** Composition d'encre pour un élément électroluminescent organique selon la revendication 1,
dans laquelle la teneur en silicium de l'agent d'unisson est de 0,1 % en masse ou plus.

**3.** Composition d'encre pour un élément électroluminescent organique selon la revendication 1 ou 2,
dans laquelle le solvant contient au moins un élément choisi dans le groupe consistant en un solvant aromatique cyclique fusionné, un solvant aromatique à base d'éther, et un solvant aromatique à base d'ester.

**4.** Composition d'encre pour un élément électroluminescent organique selon l'une quelconque des revendications 1 à 3,
dans laquelle le matériau d'élément électroluminescent organique est un matériau électroluminescent.

**5.** Composition d'encre pour un élément électroluminescent organique selon la revendication 4,
dans laquelle le matériau électroluminescent est un matériau électroluminescent de faible masse moléculaire,
dans laquelle faible masse moléculaire signifie qu'une masse moléculaire moyenne en masse (Mw) est inférieure ou égale à 5 000.

**6.** Composition d'encre pour un élément électroluminescent organique selon la revendication 4 ou 5,
dans laquelle une distance de coordonnées en trois dimensions (Ra) représentée par l'équation (a) suivante est de 10 ou moins :

[Équation mathématique 1]

$$\mathrm{Ra} = \sqrt{4} \times \{(dD)^2 + (dP)^2 + (dH)^2\} \qquad \text{(a)}$$

dans laquelle dD, dP, et dH sont une différence dans un terme de dispersion, une différence dans un terme de polarisation et une différence dans un terme de liaison hydrogène, par rapport à des paramètres de solubilité de Hansen entre le matériau électroluminescent et le solvant, respectivement,
dans laquelle une valeur mesurée et calculée en utilisant le logiciel HSPiP version 3.1.19 de calcul de paramètre de solubilité de Hansen est utilisée.

**7.** Elément électroluminescent organique comprenant :

une anode ;
une couche électroluminescente ; et
une cathode,
dans lequel la couche électroluminescente inclut un agent d'unisson, et
l'agent d'unisson est un copolymère séquencé formé en réalisant une copolymérisation d'au moins un monomère de siloxane et un monomère hydrophobe,
dans lequel le monomère hydrophobe est un monomère contenant un groupe aromatique.

**8.** Elément électroluminescent organique comprenant :

une anode ;
une couche électroluminescente ;
une cathode ; et
au moins une couche choisie dans le groupe consistant en une couche d'injection de trous, une couche de transport de trous, une couche de transport d'électrons, et une couche d'injection d'électrons,
dans lequel au moins une couche choisie dans le groupe consistant en la couche d'injection de trous, la couche de transport de trous, la couche de transport d'électrons, et la couche d'injection d'électrons inclut un agent d'unisson, et
l'agent d'unisson est un copolymère séquencé formé en réalisant une copolymérisation d'au moins un monomère de siloxane et un monomère hydrophobe,
dans lequel le monomère hydrophobe est un monomère contenant un groupe aromatique.

**9.** Elément électroluminescent organique selon la revendication 7 ou 8,
dans lequel la teneur en silicium de l'agent d'unisson est de 0,1 % à 50,0 % en masse.

[Fig. 1]

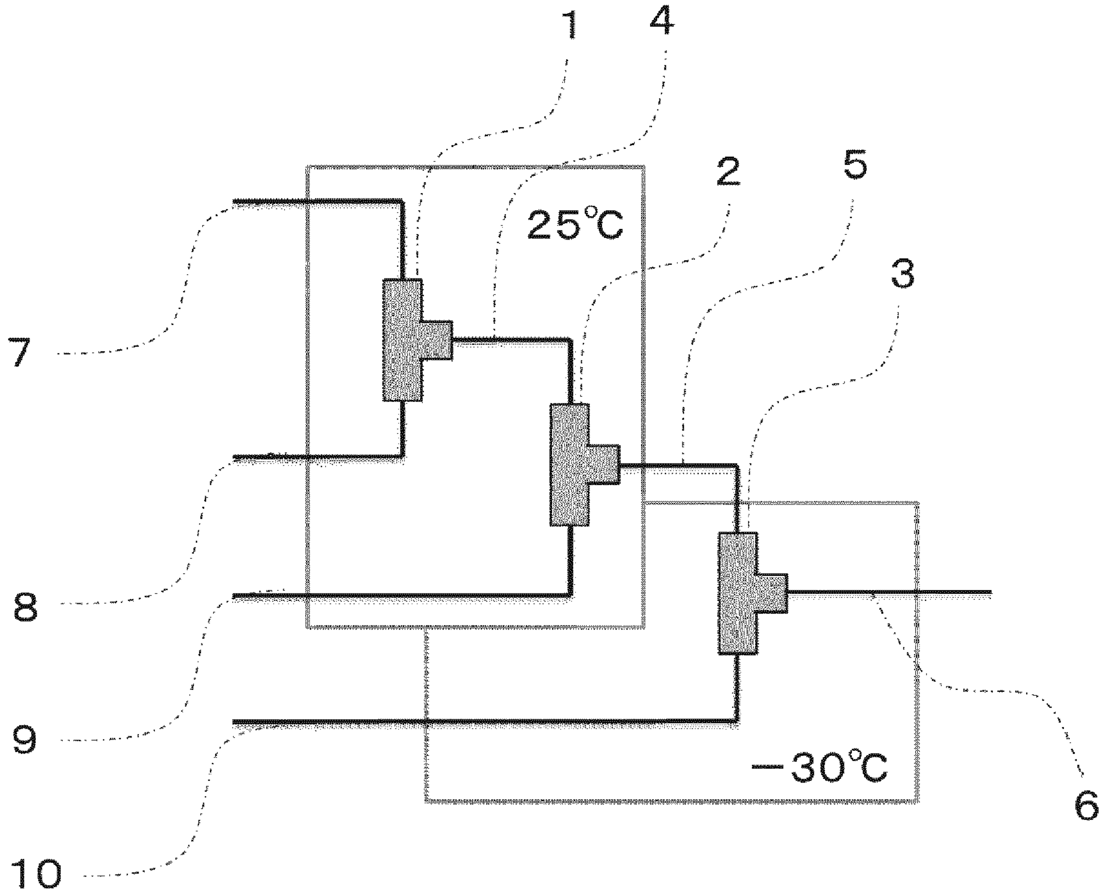

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002056980 A
- JP 2014205830 A
- JP 2005514726 A
- WO 2003019693 A
- JP H0586294 A
- EP 0534476 A